# FASCICULE DE BREVET EUROPEEN

(11) **EP 4 682 466 B1**
(45) Date de publication et mention de la délivrance du brevet: **14.10.2026**
(21) Numéro de dépôt: 25188439.1
(22) Date de dépôt: 09.07.2025
(51) Int. Cl.: G01C 19/00, G01C 19/567, G01C 19/5769, G01C 19/5783, G01P 1/02, G01C 19/56

(54) **PROCÉDÉ DE FABRICATION DE CAPTEUR INERTIEL MÉCANIQUE VIBRANT, CAPTEUR OBTENU PAR UN TEL PROCÉDÉ ET CENTRALE INERTIELLE INCLUANT UN TEL CAPTEUR**
VERFAHREN ZUR HERSTELLUNG EINES VIBRIERENDEN MECHANISCHEN TRÄGHEITSSENSORS, DURCH SOLCH EIN VERFAHREN ERHALTENER SENSOR UND TRÄGHEITSKRAFTWERK MIT SOLCH EINEM SENSOR
METHOD FOR MANUFACTURING A VIBRATING MECHANICAL INERTIAL SENSOR, SENSOR OBTAINED BY SUCH A METHOD AND INERTIAL UNIT INCLUDING SUCH A SENSOR

(30) Priorité: 09.07.2024 FR 2407479
(43) Date de publication de la demande: 21.01.2026
(73) Titulaire: Halliburton Energy Services, Inc., Houston, TX 77032-3219 (US)
(72) Inventeur: BEITIA, José Louis, 69002 LYON (FR)
(74) Mandataire: Withers & Rogers

(56) Documents cités:
- US-B2- 10 982 530
- US-B2- 8 516 886

## Description

La présente invention se rapporte au domaine technique général des capteurs inertiels de mesure de mouvement et d'orientation, comme par exemple les capteurs gyroscopiques basés sur les forces de Coriolis pour mesurer des vitesses de rotation et/ou des angles de rotation, tels que les gyromètres ou gyroscopes vibrants à effet Coriolis (CVG, Coriolis Vibratory Gyroscope), ou encore comme les accéléromètres vibrants (VBA, Vibrating Beam Accelerometer).

La présente invention concerne plus particulièrement un procédé de fabrication d'un capteur inertiel mécanique vibrant, comprenant une étape d'association d'un corps d'épreuve à une embase, ledit corps d'épreuve étant conçu pour vibrer et/ou se déformer et/ou se déplacer, ledit procédé comprenant en outre une étape d'assemblage d'un capot à ladite embase pour que ledit capot coiffe le corps d'épreuve et forme avec l'embase un boîtier au sein duquel est logé ledit corps d'épreuve.

La présente invention concerne en outre un capteur inertiel mécanique vibrant comprenant au moins une embase, un corps d'épreuve attaché à ladite embase et conçu pour vibrer et/ou se déformer et/ou se déplacer, ainsi qu'un capot qui coiffe ledit corps d'épreuve et forme avec l'embase un boîtier qui délimite un espace intérieur au sein duquel est logé ledit corps d'épreuve.

Enfin la présente invention concerne aussi une centrale inertielle incluant au moins une platine ainsi qu'au moins un capteur inertiel mécanique vibrant, ladite platine étant pourvue d'au moins un support auquel est fixé ledit capteur inertiel pour être immobilisé par rapport à ladite platine, ladite centrale inertielle incluant en outre un couvercle qui coiffe ledit capteur inertiel mécanique vibrant et est attaché à la platine pour former avec cette dernière un coffret au sein duquel est logé ledit capteur inertiel mécanique vibrant.

Les capteurs inertiels mécaniques vibrants, qui mettent en œuvre des corps d'épreuve destinés à vibrer, ou à se déplacer, ou à se déformer, sont bien connus. Ils sont utilisés pour assurer des mesures de mouvements et/ou d'orientation.

On connaît en particulier des gyromètres à structure vibrante, destinés à mesurer des vitesses angulaires. Ces gyromètres vibrants reposent sur l'effet Coriolis, qui conduit une structure vibrante, présentant un mode de résonance d'ordre 2 se déclinant en un mode primaire et un mode secondaire, orthogonaux modalement, à subir une force, lorsqu'elle tourne, pour continuer à vibrer dans un plan fixe ou partiellement entrainé avec un coefficient fixe connu, dans l'espace des modes défini par les modes primaire et secondaire. L'application d'une force opposée permet de faire tourner le plan de vibration avec la structure vibrante. La vibration est alors immobile par rapport à un repère tournant lié à la structure vibrante. La mesure de cette force permet de déterminer la vitesse angulaire. En l'absence de l'application d'une force opposée aux forces de Coriolis, la mesure de la position du repère lié à l'espace des modes, tournant par rapport à la vibration, qui elle est fixe ou partiellement entrainée avec un coefficient fixe connu, donne directement l'information d'angle de rotation de la structure vibrante. On parle alors de fonctionnement en mode gyroscope (ou « *Whole Angle (WA) mechanization* » en anglais), par opposition au précédent mode de fonctionnement, appelé mode gyromètre (ou « *Force to Rebalance (FTR) mechanization* » en anglais).

On connaît, par exemple, des capteurs gyroscopiques à effet Coriolis qui mettent en œuvre une embase à laquelle est fixée, au moyen d'un pied central, un résonateur en silice métallisé sur sa surface. Des électrodes sont disposées sur un porte-électrodes, en vis-à-vis de la paroi métallisée du résonateur, pour à la fois la mettre en vibration (via l'application de forces électrostatiques) et détecter cette dernière (via une détection de type capacitive).

On connaît aussi, par exemple, des capteurs gyroscopiques à effet Coriolis dits de type MEMS (pour « *Micro-Electro-Mechanical System* »), qui mettent en œuvre une embase à laquelle est fixée un résonateur en quartz ou en silicium rendu isolant sur sa surface par la réalisation d'une couche de dioxyde de silicium SiO₂. Des électrodes sont disposées sur les parois du résonateur et sur des surfaces attenantes pour la version silicium, en vis-à-vis, pour à la fois l'exciter en vibrations (forces électrostatiques) et détecter ces dernières (détection capacitive).

On connaît également par ailleurs des capteurs gyroscopiques qui mettent en œuvre une embase à laquelle est fixée, au moyen d'une tige centrale, un résonateur métallique. Des éléments piézoélectriques sont disposés sur et contre la paroi du résonateur métallique pour à la fois l'exciter en vibrations et détecter ces dernières par effet piézo-électrique indirect ou direct.

On connait enfin, par exemple, des capteurs accélérométriques à poutres vibrantes (VBA) utilisant une architecture mécanique préférentiellement différentielle avec une structure réalisée en technologie MEMS, soit en quartz, ou encore mieux, en silicium, pour bénéficier de la haute précision et du faible coût de production des techniques de gravures de type DRIE (Deep reactive-ion etching). Le principe de fonctionnement de ces accéléromètres repose sur la mesure des variations de fréquence de résonance de poutres vibrantes auxquelles est accrochée une masse sismique, avec, en réponse à une accélération externe, une poutre mise en tension et l'autre mise en compression. Cette approche différentielle permet de compenser les variations de température et d'autres perturbations environnementales, améliorant ainsi la précision et la stabilité de la mesure. Les variations de fréquence sont converties en signaux électriques qu'il est simple de numériser.

Ces différents capteurs à résonateur mécanique vibrant connus donnent globalement satisfaction, mais n'en présentent pas moins certains inconvénients.

En particulier, le résonateur des capteurs gyroscopiques vibrants précités est généralement fabriqué à partir de matériaux présentant des caractéristiques mécaniques spécifiques essentielles pour l'atteinte des performances, notamment en termes d'amortissement qui se doit d'être le plus faible possible. Hors il se trouve que cet amortissement est perturbé par la force électromagnétique résultant de l'interaction entre le champ magnétique externe et le courant induit à la surface du résonateur lorsque ses modes de résonance primaire et secondaire sont entretenus, que le résonateur soit intrinsèquement métallique, ou qu'il soit fabriqué à partir d'un matériau isolant (par exemple la silice), ou rendu isolant sur sa surface (le silicium), et revêtu d'électrodes conductrices. Les résonateurs métalliques en matériau ferromagnétique (comme le fer, le nickel et le cobalt) présentent par ailleurs, généralement, une magnétisation qui génère un champ magnétique qui s'additionne au champ magnétique global traversé par les surfaces conductrices du résonateur en mouvement, ce qui ajoute à la force électromagnétique mentionnée ci-dessus une cause supplémentaire perturbant l'amortissement de la vibration du résonateur. Ce champ interne additionnel perturbe également le fonctionnement de tout composant sensible aux champs magnétiques et placé dans un voisinage proche du résonateur métallique. Dans ces derniers cas, il est connu de recourir alternativement à des matériaux non magnétiques ou diamagnétiques (par exemple des alliages de cuivre) et paramagnétiques (par exemple l'aluminium), mais cela ne permet pas pour autant d'éliminer la présence de la force électromagnétique perturbatrice. Dès lors, ces capteurs gyroscopiques vibrants connus sont susceptibles d'interagir de façon intempestive avec tout champ magnétique externe, ce qui dégrade significativement leurs performances, notamment lorsqu'il s'agit de champs électromagnétiques à basse fréquence (inférieure à 1 MHz).

Les inconvénients décrits ci-dessus s'appliquent de la même façon aux accéléromètres vibrants puisque les poutres vibrantes qu'ils contiennent sont nécessairement revêtues d'électrodes, sont mises en mouvement à la fréquence de résonance de ces poutres, et lorsque le capteur traverse un champ magnétique externe, une force électromagnétique perturbatrice est créée, résultant de l'interaction de ce champ magnétique externe avec les électrodes se déplaçant dans ce champ. Les caractéristiques apparentes d'amortissement et de raideur de ces poutres sont alors perturbées, ceci conduisant à une dégradation significative de leurs performances.

C'est pourquoi, afin de préserver les performances de mesure de ces capteurs à résonateur mécanique vibrant, il est connu de les entourer d'une cage de blindage magnétique. Il est connu de former un tel blindage en utilisant un feuillet métallique d'épaisseur significative (par exemple 0,5 mm) réalisé en un matériau présentant une perméabilité magnétique élevée, comme par exemple l'alliage de nickel et de fer nommé Permalloy ^{®}, ou encore l'alliage nommé Mu-metal ^{®}.

Cependant, si de tels blindages connus permettent de protéger les capteurs inertiels à résonateur mécanique vibrant connus d'influences magnétiques extérieures, ils présentent toutefois des inconvénients sérieux. Ces blindages connus sont en effet tout d'abord mal adaptés aux capteurs de petite dimension, car alors le ratio de la surface de blindage à la surface totale diminue (incluant les zones de pliage et les espaces libres dans ces zones). Ces blindages s'avèrent être aussi particulièrement onéreux. Ils contribuent en outre de manière très significative à accroître à la fois l'encombrement et la masse du capteur inertiel à résonateur mécanique vibrant une fois blindé, puisqu'ils présentent une épaisseur importante dans le but d'obtenir un blindage efficace. La performance de ces blindages connus peut être en outre sensible à la température (désalignement magnétique), de sorte qu'ils ne sont pas appropriés pour certaines applications impliquant par exemple de soumettre le capteur inertiel à résonateur mécanique vibrant à des températures élevées. En outre, les feuillets métalliques classiquement utilisés pour former la cage de blindage magnétique voient leurs propriétés de blindage magnétique se dégrader lorsqu'ils sont soumis aux opérations de formage et d'assemblage (pliage, déformation, soudage, usinage...) requises pour former la cage, ce qui limite la possibilité de mettre en œuvre des blindages magnétiques performants dans certaines configurations et/ou requiert des étapes additionnelles de traitement de la cage (recuisson par exemple) qui compliquent la fabrication et la rendent plus onéreuse.

Cependant, concernant spécifiquement le Permalloy ^{®}, des approches moins conventionnelles que l'usinage ou le formage de feuillets pourraient être envisagées, comme par exemple le recours à un dépôt de Permalloy ^{®} en couche mince par pulvérisation cathodique magnétron (« *magnetron sputtering* » en anglais) à courant continu (DC), où des molécules de gaz ionisées bombardent un matériau cible, libérant des atomes de métal vaporisés dans un plasma qui finissent par recouvrir physiquement la surface du substrat. Ce processus est peu coûteux et peut être réalisé en série, mais la vitesse de pulvérisation est extrêmement lente, de l'ordre du nm/min, et le substrat est exposé à des températures pouvant être élevées. Ainsi, cette méthode a été principalement explorée pour la réalisation de blindages minces qui ne permettent pas d'atteindre un niveau de performance optimal pour les capteurs inertiels à résonateur mécanique vibrant. D'autres méthodes ont également été envisagées pour la réalisation de blindage en Permalloy ^{®}, comme la fusion laser sur lit de poudre (LPBF), également connue sous le nom de frittage laser direct de métal ou de fusion laser sélective. Ce procédé, bien que pertinent pour blinder des objets de forme complexe, s'avère toutefois particulièrement onéreux et lent, avec là encore une exposition du substrat à des températures élevées.

Le document US8516886B2 décrit un gyroscope comprenant un cadre de détection, une masse d'épreuve disposée à l'extérieur du cadre de détection, une paire d'ancrages et une pluralité de poutres d'entraînement.

Le document US10982530B2 décrit un ensemble gyroscopique MEMS inductif à blindage magnétique.

Les objets assignés à l'invention visent par conséquent à remédier aux différents inconvénients exposés dans ce qui précède, et à proposer un nouveau procédé de fabrication d'un capteur inertiel mécanique vibrant permettant d'obtenir, à moindre coût et de façon simple et rapide, un capteur inertiel mécanique vibrant qui, tout en étant particulièrement léger et peu encombrant, présente une conception lui permettant, indépendamment de sa taille, de maintenir son niveau de performance de mesure même lorsqu'il est soumis à des champs magnétiques externes puissants, en particulier à basses fréquences.

Un autre objet de l'invention vise à proposer un nouveau procédé de fabrication d'un capteur inertiel mécanique vibrant dont la sensibilité magnétique est particulièrement réduite sur un spectre fréquentiel relativement étendu.

Un autre objet de l'invention vise à proposer un nouveau procédé de fabrication d'un capteur inertiel mécanique vibrant qui, tout en permettant d'optimiser les performances de mesure du capteur quel que soit l'environnement de ce dernier, ne nécessite pas de recourir à une étape de recuisson.

Un autre objet de l'invention vise à proposer un nouveau procédé de fabrication d'un capteur inertiel mécanique vibrant qui se prête particulièrement bien à une mise en œuvre industrielle.

Un autre objet de l'invention vise à proposer un nouveau procédé de fabrication d'un capteur inertiel mécanique vibrant qui présente un excellent compromis entre sa précision de mesure d'une part et sa sensibilité aux champs magnétiques externes d'autre part.

Un autre objet de l'invention vise à proposer un nouveau procédé de fabrication d'un capteur inertiel mécanique vibrant qui permet d'obtenir, de façon simple et rapide, un capteur inertiel mécanique vibrant de construction particulièrement robuste et durable.

Un autre objet de l'invention vise à proposer un nouveau capteur inertiel mécanique vibrant qui présente d'excellentes performances de mesure, même lorsqu'il est soumis à des champs magnétiques externes puissants, en particulier à basses fréquences, tout en étant particulièrement léger, compact et de fabrication peu onéreuse.

Un autre objet de l'invention vise à proposer une nouvelle centrale inertielle qui présente une sensibilité magnétique réduite tout en étant particulièrement légère, robuste et compacte.

Les objets assignés à l'invention sont atteints à l'aide d'un procédé de fabrication d'un capteur inertiel mécanique vibrant, comprenant une étape d'association d'un corps d'épreuve à une embase, ledit corps d'épreuve étant conçu pour vibrer et/ou se déformer et/ou se déplacer, ledit procédé comprenant en outre une étape d'assemblage d'un capot à ladite embase pour que ledit capot coiffe le corps d'épreuve et forme avec l'embase un boîtier au sein duquel est logé ledit corps d'épreuve, une étape de tirage au vide dans ledit boîtier ou de remplissage dudit boîtier par un gaz sec, et une étape de blindage magnétique dudit boîtier qui inclut une première opération de dépôt, par galvanoplastie, d'une première couche d'un premier matériau ferromagnétique sur une partie au moins dudit boîtier.

Les objets assignés à l'invention sont également atteints à l'aide d'un capteur inertiel mécanique vibrant susceptible d'être fabriqué par le procédé selon l'invention, ledit capteur inertiel mécanique vibrant comprenant au moins une embase, un corps d'épreuve attaché à ladite embase et conçu pour vibrer et/ou se déformer et/ou se déplacer, ainsi qu'un capot qui coiffe ledit corps d'épreuve et forme avec l'embase un boîtier qui délimite un espace intérieur au sein duquel est logé ledit corps d'épreuve, ledit espace intérieur étant placé sous vide ou étant rempli par un gaz sec, ledit boîtier étant au moins en partie revêtu par une première couche d'un premier matériau ferromagnétique déposée par galvanoplastie, pour former un blindage magnétique dudit boîtier.

Les objets assignés à l'invention sont enfin atteints à l'aide d'une centrale inertielle incluant au moins une platine ainsi qu'au moins un capteur inertiel mécanique vibrant selon l'invention, ladite platine étant pourvue d'au moins un support auquel est fixé ledit capteur inertiel mécanique vibrant pour être immobilisé par rapport à ladite platine, ladite centrale inertielle incluant en outre un couvercle qui coiffe ledit capteur inertiel mécanique vibrant et est attaché à la platine pour former avec cette dernière un coffret au sein duquel est logé ledit capteur inertiel mécanique vibrant, ledit coffret étant au moins en partie revêtu par une couche secondaire dudit premier matériau ferromagnétique déposée par galvanoplastie.

D'autres particularités et avantages de l'invention apparaîtront à la lecture de la description détaillée qui suit, en référence aux dessins annexés, donnés à titre d'exemples purement illustratifs et non limitatifs, dans lesquels :
La figure 1 illustre, selon une vue schématique en perspective de dessus, un premier mode de réalisation d'un capteur inertiel mécanique vibrant conforme à l'invention, qui est en l'occurrence un capteur gyroscopique vibrant de type CRG (à résonateur cylindrique).
La figure 2 illustre, selon une vue schématique en perspective de dessous, le capteur gyroscopique vibrant de la figure 1.
La figure 3 illustre, selon une vue schématique en perspective coupée, le capteur gyroscopique vibrant des figures 1 et 2.
La figure 4 illustre, selon une vue schématique en perspective de dessus, un détail de réalisation du capteur gyroscopique vibrant des figures 1 à 3, correspondant en l'espèce à son embase.
La figure 5 illustre, selon une vue schématique en perspective de dessous, l'embase de la figure 4.
La figure 6 illustre, selon une vue schématique en perspective de dessous, un détail de réalisation du capteur gyroscopique vibrant des figures 1 à 3, correspondant en l'espèce à son capot.
La figure 7 illustre, selon une vue schématique en coupe, le capot de la figure 6.
La figure 8 illustre, selon une vue schématique en perspective coupée, un deuxième mode de réalisation d'un capteur inertiel mécanique vibrant conforme à l'invention, qui est en l'occurrence un capteur gyroscopique vibrant de type HRG (« Hemispherical Resonator Gyroscope », ou en français : gyroscope vibrant à résonateur hémisphérique).
La figure 9 illustre, selon une vue schématique en perspective, un troisième mode de réalisation d'un capteur inertiel mécanique vibrant conforme à l'invention, qui est en l'occurrence un accéléromètre à poutres vibrantes (VBA) de type MEMS (système microélectromécanique).

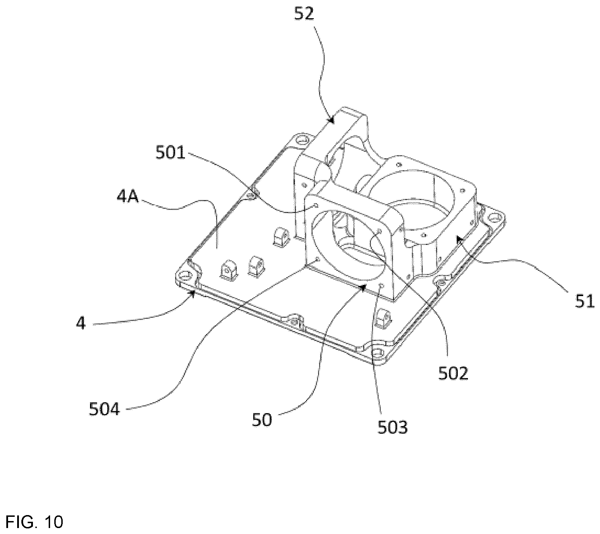

La figure 10 illustre, selon une vue schématique en perspective de dessus, un détail de réalisation d'une centrale inertielle selon l'invention, correspondant à une platine sur laquelle sont destinés à être montés, selon respectivement les trois directions de l'espace, trois capteurs gyroscopiques conformes à l'invention et/ou trois accéléromètres conformes à l'invention.

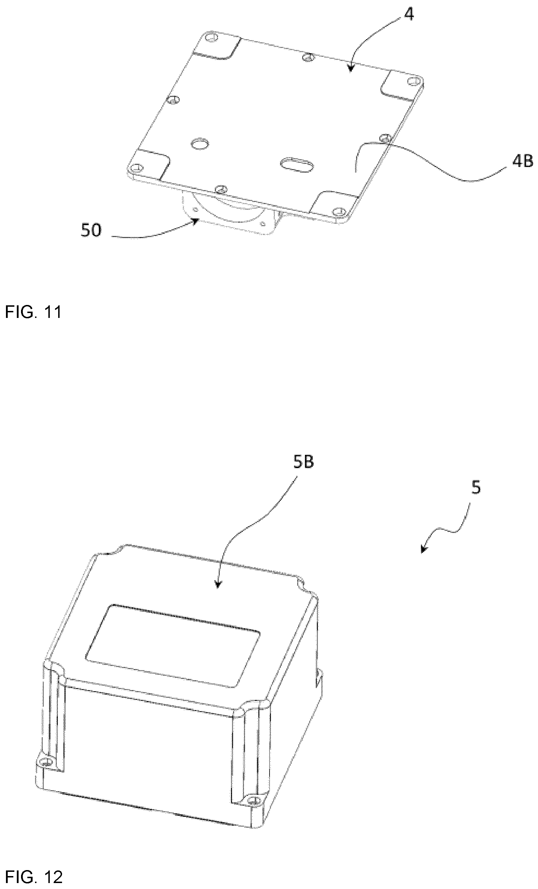

La figure 11 illustre, selon une vue schématique en perspective de dessous, la platine de la figure 10.
La figure 12 illustre, selon une vue schématique en perspective de dessus, un détail de réalisation d'un mode de réalisation de la centrale inertielle selon l'invention, correspondant à un couvercle destiné à coiffer la platine et les capteurs inertiels portés par cette dernière.

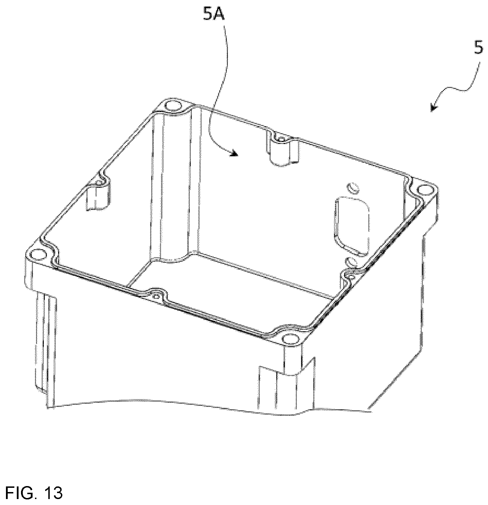

La figure 13 illustre, selon une vue schématique en perspective de dessous, le couvercle de la figure 12.

L'invention concerne un procédé de fabrication d'un capteur inertiel mécanique vibrant 1, ainsi qu'un capteur inertiel mécanique vibrant 1 susceptible d'être fabriqué par ledit procédé. Ledit capteur inertiel mécanique vibrant 1 selon l'invention est de préférence obtenu par le procédé de fabrication selon l'invention, tandis que le procédé de fabrication selon l'invention est préférentiellement un procédé de fabrication du capteur inertiel mécanique vibrant 1 selon l'invention. Toutefois, il est parfaitement envisageable par exemple que le capteur inertiel mécanique vibrant 1 selon l'invention puisse être obtenu par un procédé de fabrication autre que le procédé selon l'invention, et inversement que le procédé de fabrication selon l'invention puisse permettre d'obtenir un capteur inertiel mécanique vibrant qui diffère du capteur inertiel mécanique vibrant 1 selon l'invention. Par souci de concision, la description qui suit concernera à la fois ledit procédé selon l'invention et ledit capteur inertiel mécanique vibrant 1 selon l'invention, ce qui signifie que les éléments de la description qui suit relatifs audit procédé de fabrication s'appliquent, *mutatis mutandis,* audit capteur inertiel mécanique vibrant 1, et réciproquement que les éléments de la description qui suit relatifs audit capteur inertiel mécanique vibrant 1 s'appliquent, *mutatis mutandis,* audit procédé de fabrication.

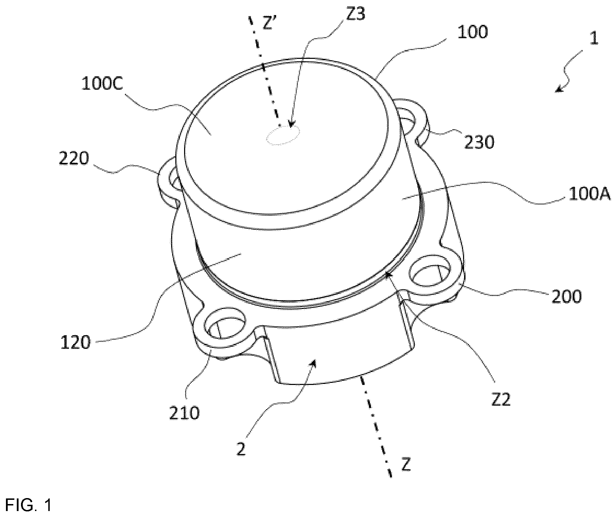

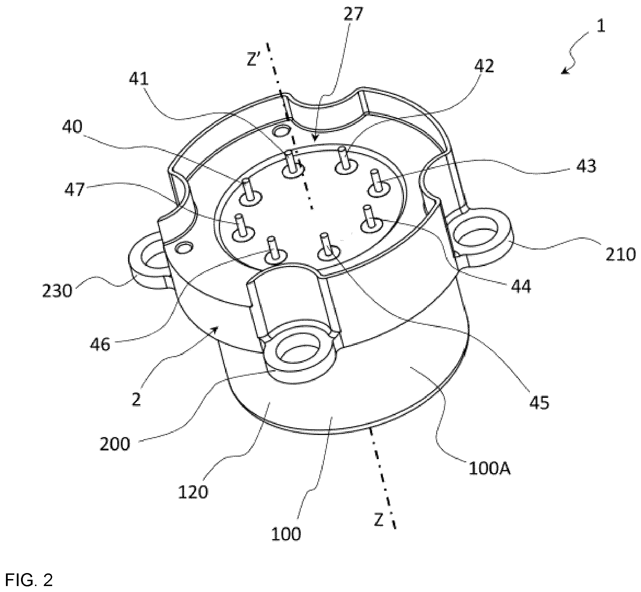

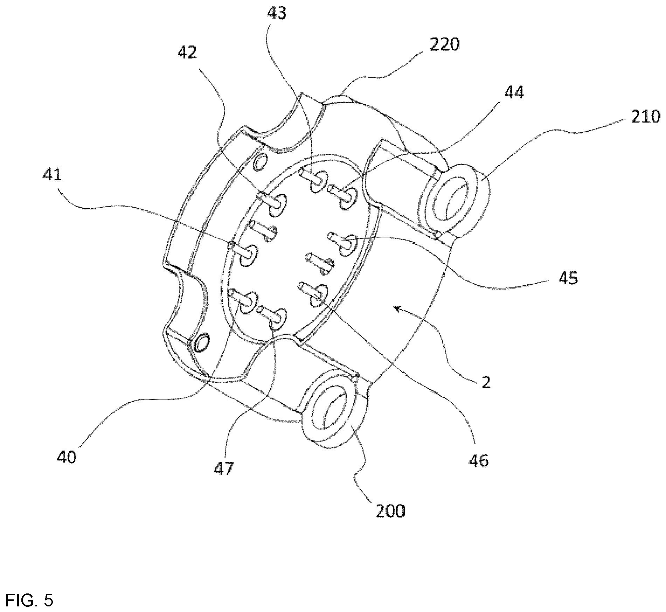

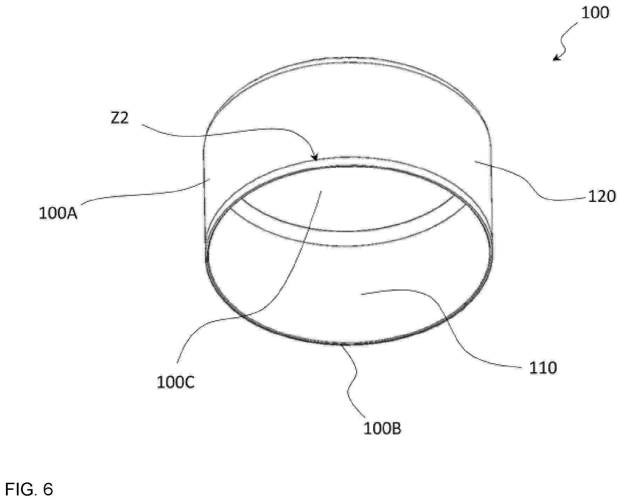

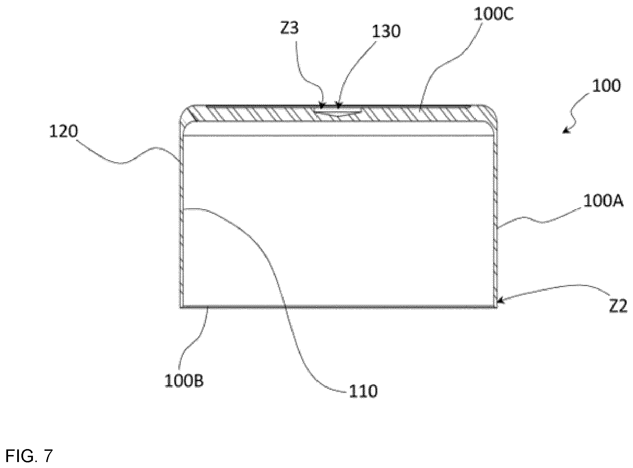

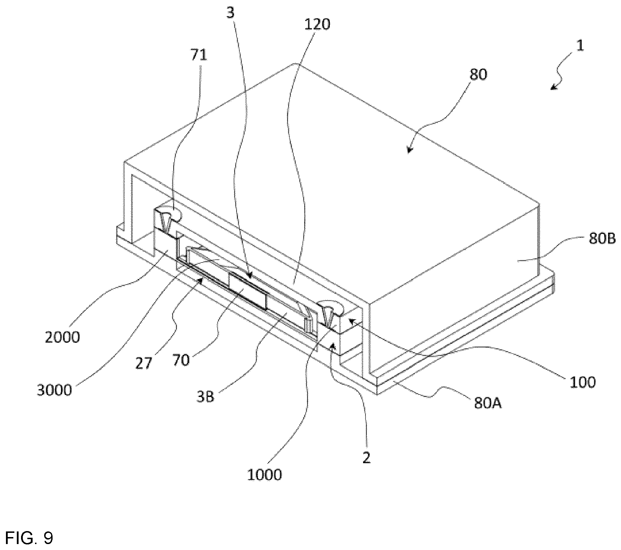

Le procédé de fabrication selon l'invention comprend une étape d'association d'un corps d'épreuve 3 à une embase 2. Ledit corps d'épreuve 3 est conçu pour vibrer et/ou se déformer et/ou se déplacer, par exemple globalement ou localement, de façon que ses possibilités de vibration et/ou de déformation et/ou de déplacement puissent être exploitées pour déterminer par exemple des caractéristiques d'un mouvement et/ou d'une orientation. Ladite embase 2 est par exemple métallique (comme dans les modes de réalisation des figures 1 à 8) ou en verre ou en silice (comme dans le mode de réalisation de la figure 9), et assure de préférence notamment une fonction de support. L'embase 2 constitue ainsi par exemple un socle pour le corps d'épreuve 3 qui lui est attaché. L'embase 2 est par exemple pourvue, comme illustré aux figures 1 à 5, de moyens de fixation 200, 210, 220, 230, qui se présentent par exemple sous la forme d'une pluralité d'oreilles de fixation traversées chacune par un orifice afin de permettre une fixation par vissage du capteur inertiel 1 à un bâti, par exemple à une platine 4 d'une centrale inertielle ou de tout autre équipement.

Conformément aux modes de réalisation des figures 1 à 8, ledit capteur inertiel mécanique 1 est par exemple un capteur gyroscopique vibrant, de préférence axisymétrique, à effet Coriolis, c'est-à-dire un capteur vibratoire basé sur les forces de Coriolis. Ledit capteur gyroscopique vibrant est ainsi un capteur inertiel vibrant de type CVG (acronyme anglophone de « *Coriolis Vibratory Gyroscope* »). Il forme dans ce cas avantageusement un capteur conçu (i) pour mesurer un angle de rotation (fonctionnement en gyroscope, également appelé mode WA comme évoqué ci-avant), auquel cas il constitue un gyroscope vibrant et/ou (ii) pour mesurer une vitesse de rotation (fonctionnement en gyromètre, également appelé mode FTR comme évoqué ci-avant), auquel cas il constitue un gyromètre vibrant, étant entendu que ledit gyromètre peut également déterminer un angle par intégration de la vitesse angulaire.

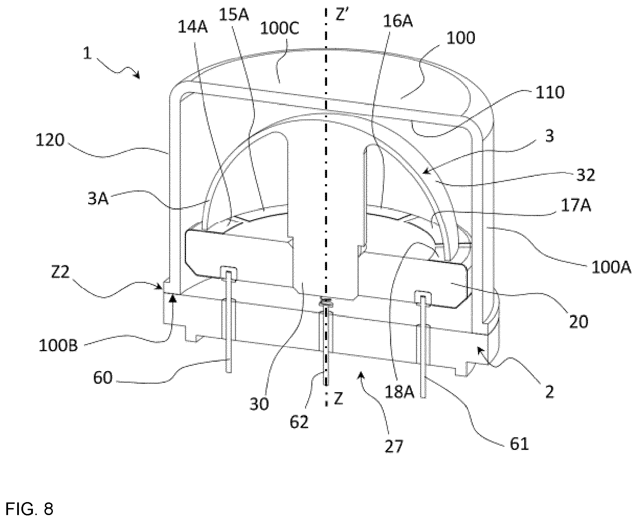

L'invention n'est pas limitée à un type spécifique de capteur gyroscopique vibrant. Ce dernier peut par exemple former un capteur gyroscopique à résonateur cylindrique (ou CRG pour « *Cylindrical Resonator Gyroscope* ») comme dans le mode de réalisation des figures 1 à 7, ou bien un capteur gyroscopique à résonateur hémisphérique (ou HRG pour « *Hemispherical Resonator Gyroscope* ») comme dans le mode de réalisation de la figure 8, ou encore par exemple un capteur gyroscopique MEMS dont le résonateur prend la forme d'un anneau généralement en silicium, ou dont le résonateur est constitué de quatre masses oscillantes formant deux paires vibrant à la même fréquence mais en opposition de phase (on parle dans ce cas de « double diapason plan »).

L'invention n'est en outre pas limitée à un capteur inertiel mécanique vibrant qui forme un capteur gyroscopique vibrant. Ainsi, le capteur inertiel mécanique vibrant 1 est par exemple un accéléromètre à poutres vibrantes, et en particulier un accéléromètre VBA de type MEMS (système microélectromécanique) silicium capacitif, ou quartz, comme dans le mode de réalisation de la figure 9.

Dans les modes de réalisation des figures 1 à 8, le corps d'épreuve 3 est formé par un résonateur 3A, qui est destiné à vibrer en réponse à une excitation. Ledit résonateur 3A présente par exemple au moins un mode de résonance d'ordre 2 se déclinant en un mode primaire et un mode secondaire orthogonaux modalement, de déformées par exemple elliptiques (cas d'un résonateur 3A présentant une forme de révolution, comme illustré aux figures), et en principe de mêmes fréquences.

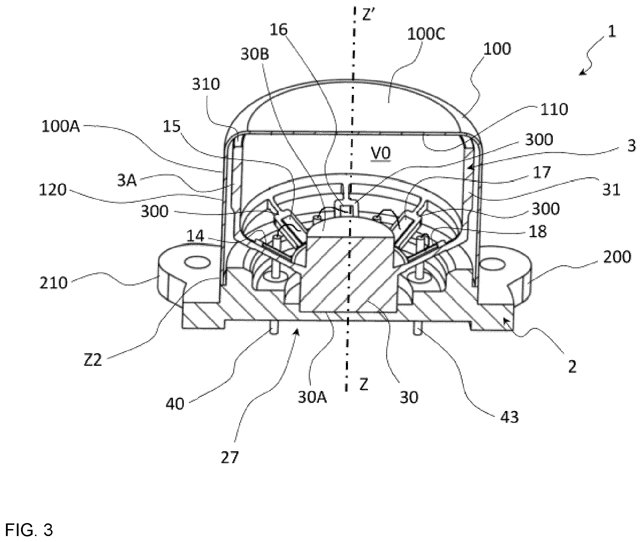

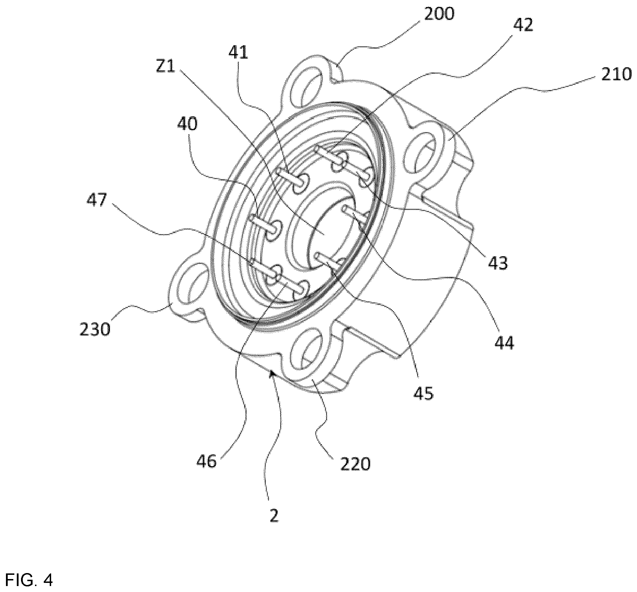

Le résonateur 3A inclut avantageusement, comme illustré aux figures 3 et 8, un pied central 30 par lequel le résonateur 3A est attaché, directement (figure 3) ou indirectement (figure 8) à ladite embase 2, par exemple en une zone de fixation Z1 de cette dernière pour le mode de réalisation des figures 3 et 4. Avantageusement, ledit pied central 30 présente un caractère monolithique massif, c'est-à-dire qu'il est formé par une pièce monobloc, d'un seul tenant, par exemple en métal ou en silice ou silicium. Dans les modes de réalisation des figures 3 et 8, ladite étape d'association du corps d'épreuve 3 à l'embase 2 inclut une opération de fixation du résonateur 3A à l'embase 2 par fixation du pied central 30, par exemple par soudage, brasage ou collage, soit directement à l'embase 2, au niveau de la zone de fixation Z1 (cas de la figure 3), soit à un plateau intermédiaire 20 (mode de réalisation de la figure 8) qui est par exemple métallique ou en verre ou céramique. Ledit plateau intermédiaire 20 est lui-même avantageusement relié à l'embase 2, par exemple selon un agencement sur pilotis, par l'intermédiaire de tiges électriquement conductrices 60, 61 (et six autresnon représentées mais qui se déduisent des précédentes par symétrie). Le capteur gyroscopique vibrant 1 selon les modes de réalisation des figures 1 à 8 comprend ainsi avantageusement des moyens de liaison mécanique qui assurent une solidarisation directe ou indirecte du pied central 30 à l'embase 2, afin d'établir de préférence une liaison encastrement entre le pied central 30 et l'embase 2, pour immobiliser le pied central 30 relativement à l'embase 2. De préférence, le pied 30 présente sensiblement une forme de révolution selon un axe central Z-Z' qui correspond par exemple à l'axe sensible selon lequel le capteur gyroscopique vibrant de chaque figure 3 et 8 est conçu pour mesurer une vitesse angulaire et/ou un déplacement angulaire. Dans le mode de réalisation des figures 1 à 7 le pied 30 s'étend par exemple, selon ledit axe central Z-Z', entre une face extérieure 30A, qui est de préférence plane et est par exemple reçue dans un logement ménagé dans l'embase 2 et qui forme la zone de fixation Z1, et une face intérieure 30B libre, qui est de préférence plane elle aussi.

Dans le mode de réalisation des figures 1 à 7, le résonateur 3A comprend un cylindre vibrant 31, qui est préférentiellement attaché audit pied 30, ce dernier portant avantageusement le cylindre vibrant 31. Le cylindre vibrant 31 présente avantageusement une forme de révolution, selon ledit axe central Z-Z'. Il s'élève par exemple entre un bord inférieur relié au pied 30, par exemple par des bras 300, et un bord supérieur libre 310 qui délimite une ouverture donnant accès à un volume intérieur V0. Le cylindre vibrant 31 forme ainsi une paroi latérale qui entoure le volume intérieur V0. Chaque bras 300 est par exemple formé par une patte rigide, qui s'étend radialement par rapport à l'axe central Z-Z', autour et à partir du pied 30, pour relier ce dernier au cylindre vibrant 31. Comme illustré aux figures, le cylindre vibrant 31 présente avantageusement une forme générale de cylindre circulaire droit, qui s'étend préférentiellement entre un bord circulaire inférieur relié au pied 30, et un bord circulaire supérieur libre. Avantageusement, le pied central 30 et le cylindre vibrant 31 forment une seule et même pièce d'un seul tenant, et sont de préférence formés d'un même matériau. Le pied 30 et la paroi latérale 31 forment en d'autres termes une même pièce monobloc, qui est de préférence entièrement métallique. Avantageusement, le cylindre vibrant 31 est réalisé en acier martensitique, par exemple en acier X30Cr13, ou par exemple en acier Maraging. Le recours à l'un ou l'autre des aciers précités s'avère particulièrement avantageux car les aciers en question présentent d'excellentes propriétés en matière d'amortissement mécanique, qui permettent d'obtenir un facteur de qualité (Q) élevé, gage d'un excellent niveau de performance de mesure du capteur gyroscopique vibrant 1.

Dans le mode de réalisation de la figure 8, le résonateur 3A comprend avantageusement une coque hémisphérique vibrante 32 relié au pied 30 en son centre, ladite coque 32 étant de préférence en quartz, ou en saphir, ou en verre de silice, préférentiellement métallisée sur sa surface, et forme avantageusement une pièce d'un seul tenant avec le pied 30.

Avantageusement, dans les modes de réalisation des figures 1 à 8, le procédé comprend une étape d'association d'au moins un dispositif d'excitation audit résonateur 3A, pour l'exciter en vibration, et plus précisément pour exciter en vibration le cylindre vibrant 31 (figure 3) ou la coque hémisphérique vibrante 32 (figure 8), et notamment lesdits modes primaire et secondaire de vibrations symétriques du résonateur 3A. Avantageusement, le procédé comprend également une étape d'association d'au moins un dispositif de détection audit résonateur 3A, pour détecter des vibrations dudit résonateur 3, et en particulier les vibrations du cylindre vibrant 31 ou de la coque hémisphérique vibrante 32 excité(e) par ledit au moins un dispositif d'excitation attaché audit résonateur 3A. Les dispositifs d'excitation et de détection peuvent être de natures similaires ou différentes, et reposer par exemple sur un principe d'excitation de nature électrostatique, électromagnétique et/ou piézoélectrique, respectivement de détection de nature électrostatique, optique, électromagnétique et/ou piézoélectrique, sans que cette liste ne soit limitative.

De préférence, comme dans le cas des figures 1 à 7, le capteur gyroscopique vibrant qui forme avantageusement le capteur inertiel 1 comprend des éléments piézoélectriques 14, 15, 16, 17, 18 (et trois autres non représentés mais qui se déduisent des précédents par symétrie) qui forment à la fois lesdits dispositifs d'excitation et lesdits dispositifs de détection. Chacun desdits éléments piézoélectriques est ainsi conçu pour d'une part impartir au cylindre vibrant 31 (figure 3) des vibrations, afin d'exciter en particulier les modes primaire et secondaire symétriques de résonance, et d'autre part détecter les vibrations dudit cylindre vibrant 31. Les éléments piézoélectriques 14, 15, 16, 17, 18 (et trois autres non représentés mais qui se déduisent des précédents par symétrie) assurent ainsi une double fonction, d'excitation vibratoire d'une part et/ou de détection vibratoire d'autre part, avec une multitude de sous variantes possibles utilisant un nombre variable d'éléments piézoélectriques pour la détection et l'excitation. Dans le mode de réalisation illustré aux figures 1 à 7, lesdites étapes d'association des dispositifs d'excitation et de détection incluent par exemple une opération de fixation des éléments piézoélectriques 14, 15, 16, 17, 18 (et trois autres non représentés mais qui se déduisent des précédents par symétrie) respectivement sur chacun des bras 300 qui assurent la liaison entre le pied 30 d'une part et le cylindre vibrant 31 d'autre part. Les éléments piézoélectriques 14, 15, 16, 17, 18 (et trois autres non représentés mais qui se déduisent des précédents par symétrie) sont par exemple fixés par collage ou par brasage sur la surface supérieure de chacun desdits bras 300, ce qui permet à certains d'entre eux d'impartir des vibrations auxdits bras 300, pour que ces derniers communiquent à leur tour les vibrations en question au cylindre vibrant 31 auxquels ils sont attachés. Inversement, les vibrations dudit cylindre 31 sont transmises à chacun des bras 300 et ainsi détectées par certains des éléments piézoélectriques 14, 15, 16, 17, 18 (et trois autres non représentés mais qui se déduisent des précédents par symétrie) fixées auxdits bras 300.

De préférence, dans le cas de la figure 8, le capteur gyroscopique vibrant qui forme avantageusement le capteur inertiel 1 comprend des électrodes 14A, 15A, 16A, 17A, 18A (et trois autres non représentées mais qui se déduisent des précédentes par symétrie), disposées sur la surface du plateau intermédiaire 20 en vis-à-vis du résonateur 3A, qui forment à la fois lesdits dispositifs d'excitation et lesdits dispositifs de détection, en combinaison avec l'électrode déposée sur la surface attenante du résonateur 3A et qui se trouve reliée par un ou des dépôts conducteurs, en général de même nature que l'électrode attenante sur le résonateur, cheminant sur les parois du résonateur 3A, puis le long du pied 30, vers un contact électrique obtenu par une liaison électrique élastique avec une tige électriquement conductrices 62, en général colinéaire de l'axe de symétrie Z-Z', et traversant l'embase 2 de la même façon que les tiges 60, 61 (et six autres non représentées mais qui se déduisent des précédentes par symétrie). Chacune desdites électrodes est ainsi conçue pour d'une part impartir à la coque hémisphérique vibrante 32 (figure 8) des vibrations, afin d'exciter en particulier les modes primaire et secondaire symétriques de résonance, et d'autre part détecter les vibrations de ladite coque hémisphérique vibrante 32. Les électrodes 14A, 15A, 16A, 17A, 18A (et trois autres non représentées mais qui se déduisent des précédentes par symétrie) assurent ainsi une double fonction, d'excitation vibratoire d'une part et/ou de détection vibratoire d'autre part. Dans le mode de réalisation illustré en figure 8, lesdites étapes d'association des dispositifs d'excitation et de détection incluent par exemple une opération de dépôt des électrodes 14A, 15A, 16A, 17A, 18A (et trois autres non représentées mais qui se déduisent des précédentes par symétrie) respectivement sur le plateau intermédiaire 20 qui assure la liaison entre le pied 30 d'une part et la coque hémisphérique vibrante 32 d'autre part. Les électrodes 14A, 15A, 16A, 17A, 18A (et trois autres non représentées mais qui se déduisent des précédentes par symétrie) sont par exemple déposées selon un procédé de dépôt physique sous vide (PVD, Physical Vapor Deposition), et impartissent des vibrations à la coque hémisphérique vibrante 32 sous l'effet de forces électrostatiques dès lors qu'une différence de potentiel apparait entre ces électrodes et la métallisation en vis-à-vis du résonateur 3A. Inversement, les vibrations de ladite coque hémisphérique vibrante 32 sont détectées par modulation de la capacité entre lesdites électrodes et la métallisation du résonateur, résultant de la modulation de l'entrefer entre la coque hémisphérique vibrante 32 et la plaque intermédiaire 20 portant ces électrodes.

Dans le mode de réalisation particulier de la figure 9, selon lequel le capteur inertiel 1 est un accéléromètre vibrant (VBA) de type MEMS (système microélectromécanique), le corps d'épreuve 3 est formé par une masse d'épreuve qui est par exemple réalisée par micro-usinage d'une plaquette de silicium 3B. Le micro-usinage en question est par exemple effectué par un procédé de gravure DRIE (« Deep Reactive Ion Etching ») qui permet de découper dans la plaquette de silicium 3B un élément formant une masse d'épreuve soutenue par des bras élastiques 3000 (visibles sur la figure 9), ces bras étant eux-mêmes reliés aux deux extrémités d'une poutre fine de cette même plaquette, et ancrés au reste de la plaquette de silicium 3B. La masse d'épreuve sur ces bras élastiques forme un système masse-ressort, provoquant, en présence d'une accélération dans le plan de la plaquette de silicium 3B, une compression, ou un étirement de la poutre qui conduit au changement de la fréquence de cette poutre. Un système avec deux poutres fonctionnant en opposition de phase, l'une étant comprimée, alors que l'autre est simultanément étirée, permet avantageusement de bénéficier d'un effet différentiel qui élimine les erreurs et sensibilités de mode commun (figure 9). La mesure de la différence de fréquence des deux poutres est proportionnelle à l'accélération externe appliquée à la masse d'épreuve. Chaque poutre est pourvue avantageusement en surface d'une ou plusieurs électrodes électriquement conductrices, assurant des fonctions de détection, préférentiellement disposées sur les ventres de vibration de ladite poutre, avec en vis-à-vis, une ou des électrodes 70 immobiles et solidaires d'une partie fixe de la plaquette de silicium. Les électrodes de détection mesurent la modulation de l'entrefer entre la poutre vibrante et l'électrode fixe 70, via la modulation de capacité entre ces électrodes, pour en déduire par des moyens électroniques externes, la fréquence de cette modulation portant l'information d'accélération. Dans ce mode de réalisation particulier, l'embase 2 est formée de préférence par une première pièce de support 2000 en verre ou en silicium, qui présente avantageusement une face interne concave destinée à venir en regard de la plaquette de silicium 3B. De préférence, la plaquette de silicium 3B, qui porte la masse d'épreuve formant le corps d'épreuve 3, est solidarisée par thermocompression à ladite première pièce de support 2000 sur des surfaces métallisées en vis-à-vis, ladite première pièce de support 2000 formant avantageusement l'embase 2.

Avantageusement, le procédé comprend une étape de fourniture de moyens électroniques de traitement et de commande, qui incluent par exemple une carte électronique (non illustrée), au cours de laquelle lesdits moyens électroniques de traitement et de commande (carte électronique) sont logés au moins en partie dans l'embase 2, ou contre cette dernière, ou encore à proximité de cette dernière.

Dans les modes de réalisation des figures 1 à 8, lesdits moyens électroniques de traitement et de commande sont disposés dans un logement 27 ménagé à la surface externe de l'embase 2, du côté opposé à celui du côté duquel s'élève le résonateur 3A (figures 3 et 8). L'embase 2 s'étend ainsi avantageusement, dans les modes de réalisation des figures 1 à 8, entre la carte électronique d'une part et le résonateur 3A d'autre part.

Dans les modes de réalisation des figures 1 à 7, afin de relier électriquement à la carte électronique précitée les éléments piézoélectriques 14, 15, 16, 17, 18 (et trois autres non représentés mais qui se déduisent des précédents par symétrie), qui forment préférentiellement les dispositifs d'excitation et de détection, le procédé de fabrication comprend avantageusement une étape d'association de tiges (métalliques) électriquement conductrices 40, 41, 42, 43, 44, 45, 46, 47 à l'embase 2, par insertion desdites tiges 40, 41, 42, 43, 44, 45, 46, 47 dans des orifices traversant ladite embase 2 pour que lesdites tiges fassent saillie de part et d'autre de l'embase 2, comme illustré aux figures. Lesdites tiges 40, 41, 42, 43, 44, 45, 46, 47 sont destinées à être connectées électriquement auxdits dispositifs d'excitation et/ou de détection, c'est-à-dire par exemple (comme dans le mode de réalisation des figures 1 à 7) auxdits éléments piézoélectriques 14, 15, 16, 17, 18 (et trois autres non représentés mais qui se déduisent des précédents par symétrie) de préférence au moyen de micro-câbles (visibles sur la figure 3). Chaque tige conductrice 40, 41, 42, 43, 44, 45, 46, 47 présente avantageusement un caractère sensiblement rigide, tandis que les micro-câbles présentent un caractère souple et flexible, et sont par exemple réalisés en métal (de préférence en aluminium ou en or). Plus précisément, chaque tige conductrice 41, 42, 43, 44, 45, 46, 47 s'étend de préférence entre une extrémité inférieure, qui est destinée à être connectée électriquement à la carte électronique disposée dans le logement 27, et une extrémité supérieure au niveau de laquelle est par exemple attaché le micro-câble qui relie la tige conductrice concernée à l'un des éléments piézoélectriques 14, 15, 16, 17, 18 (et trois autres non représentés mais qui se déduisent des précédents par symétrie) précités. Les tiges conductrices 40, 41, 42, 43, 44, 45, 46, 47 traversent chacune avantageusement une paroi de support de l'embase 2, par des passages ménagés à travers ladite paroi de support et qui sont munis de traversées isolantes (par exemple en verre, de préférence à coefficient de dilatation thermique adapté à celui de l'embase 2) formant localement une gaine électriquement isolante qui entoure chaque tige conductrice pour éviter qu'elle n'entre en contact avec ladite paroi de support, laquelle est par exemple métallique. Les tiges conductrices 40, 41, 42, 43, 44, 45, 46, 47 traversent ainsi l'embase 2 jusqu'à émerger dans le logement 27, où elles sont connectées électriquement à la carte électronique susvisée (non représentée sur la figure 3).

Dans les modes de réalisation de la figure 8, afin de relier électriquement à la carte électronique précitée les électrodes 14A, 15A, 16A, 17A, 18A (et trois autres non représentés mais qui se déduisent des précédents par symétrie), qui forment préférentiellement les dispositifs d'excitation et de détection, le procédé de fabrication comprend avantageusement une étape d'association à l'embase 2 de tiges (métalliques) électriquement conductrices 60, 61 (par exemple au nombre de 8 disposées symétriquement autour de l'axe Z-Z'), ainsi que par exemple d'une tige centrale 62 avantageusement alignée avec l'axe du pied 30 et permettant l'acheminement d'une haute tension électrique vers la métallisation du résonateur 3A, par insertion desdites tiges dans des orifices traversant ladite embase 2 pour que lesdites tiges fassent saillie de part et d'autre de l'embase 2, comme illustré à la figure 8. Lesdites tiges sont destinées à être connectées électriquement auxdits dispositifs d'excitation et/ou de détection, c'est-à-dire par exemple, comme dans le mode de réalisation de la figure 8, aux électrodes 14A, 15A, 16A, 17A, 18A (et trois autres non représentées mais qui se déduisent des précédentes par symétrie), de préférence au moyen de soudures (visibles sur la figure 8). Chaque tige conductrice 60, 61 présente avantageusement un caractère sensiblement rigide. Plus précisément, chaque tige conductrice 60, 61 s'étend de préférence entre une extrémité inférieure, qui est destinée à être connectée électriquement à la carte électronique disposée dans le logement 27, et une extrémité supérieure au niveau de laquelle est réalisée la soudure au plateau intermédiaire 20. Les tiges conductrices 60, 61 traversent chacune avantageusement une paroi de support de l'embase 2, par des passages ménagés à travers ladite paroi de support et qui sont munis de traversées isolantes (par exemple en verre) formant localement une gaine électriquement isolante qui entoure chaque tige conductrice pour éviter qu'elle n'entre en contact avec ladite paroi de support, laquelle est par exemple métallique. Les tiges conductrices 60, 61 traversent ainsi l'embase 2 jusqu'à émerger dans le logement 27, où elles sont connectées électriquement à la carte électronique susvisée (non représentée sur la figure 8).

Comme illustré aux figures, le procédé comprend par ailleurs une étape d'assemblage d'un capot 100 à ladite embase 2, pour que ledit capot 100 coiffe ledit corps d'épreuve 3 et forme avec l'embase 2 un boîtier au sein duquel est logé ledit corps d'épreuve 3. Le sous-ensemble formé par ce boîtier et le corps d'épreuve 3 logé en son sein est généralement désigné par l'appellation « *élément sensible* » et constitue la partie électromécanique du capteur inertiel 1, qui par ailleurs nécessite des moyens électroniques connus (non illustrés) pour sa mise en œuvre et qui ont été évoqués ci-avant. L'appellation boitier peut être indifféremment utilisée pour désigner le boitier à l'état assemblé, c'est à dire résultant de ladite étape d'assemblage dudit capot 100 à ladite embase 2, ou le boitier à l'état non assemblé où le capot 100 et l'embase 2 sont encore séparées l'un de l'autre. Ledit capot 100 est par exemple réalisé en un matériau métallique (figures 1 à 8) ou en verre ou en silicium (figure 9), et est avantageusement destiné à coopérer avec l'embase 2 pour délimiter avec cette dernière un espace interne fermé qui accueille la structure mécanique sensible (corps d'épreuve 3 décrit ci-avant) du capteur inertiel 1, afin de l'isoler et de la protéger de l'environnement extérieur. Le logement ainsi formé par l'embase 2 et le capot 100 est avantageusement étanche au gaz, grâce à la mise en œuvre de moyens d'étanchéité appropriés disposés à l'interface entre le capot 100 et l'embase 2, ce qui permet de contrôler l'atmosphère régnant au sein du logement en question.

Par exemple, comme dans les modes de réalisation des figures 1 à 8, le capot 100 présente une forme de cloche, avec une paroi latérale cylindrique 100A présentant un bord libre 100B, ainsi qu'une paroi de fond 100C à partir et à la périphérie de laquelle s'étend ladite paroi latérale cylindrique 100A. Le capot 100 présente ainsi une forme de capuchon, ou de récipient, qui délimite avec l'embase 2 une enceinte, de préférence hermétique, au sein de laquelle le corps d'épreuve 3 est logé. Le capot 100 présente ainsi avantageusement une face interne 110 destinée à se trouver en regard de l'intérieur du boîtier et une face externe 120 opposée. Avantageusement, ladite étape d'assemblage du capot 100 à l'embase 2 inclut une opération d'accostage pour que le bord libre 100B vienne au contact de ladite embase 2, selon une interface de contact qui est par exemple continue, et de préférence circulaire. Ladite étape d'assemblage du capot 100 à l'embase 2 inclut également, après ladite opération d'accostage, une opération de soudage ou brasage pour réaliser un cordon de soudure ou brasure, de préférence sensiblement continu, reliant l'embase 2 à une zone terminale Z2 de la paroi latérale cylindrique 100A située au voisinage du bord libre 100B, sur la face externe 120 du capot 100. Par exemple, comme illustré aux figures 1 à 8, ladite zone terminale Z2 forme une bande circonférentielle qui s'étend, à partir du bord libre 100B, sur une fraction (par exemple au plus 10 %, de façon encore plus préférentielle au plus 5 %, et de façon particulièrement préférentielle au plus 3 %) de la hauteur de la paroi latérale cylindrique 100A (mesurée parallèlement à l'axe central Z-Z'). Ladite opération de soudage ou de brasage est ainsi menée pour que le cordon de soudure adhère à la fois à ladite zone terminale Z2 et à une zone circonférentielle de l'embase 2 qui est adjacente à ladite zone terminale Z2, pour attacher le capot 100 à l'embase 2, tout en formant de préférence un joint d'étanchéité hermétique à l'interface entre le capot 100 et l'embase 2.

Dans le mode de réalisation de la figure 9 (capteur inertiel 1 formant un accéléromètre vibrant (VBA) MEMS), le capot 100 est avantageusement formé par une deuxième pièce de support 1000 en verre ou en silicium, qui présente avantageusement une face interne concave destinée à venir en regard de la plaquette de silicium 3B dans laquelle est ménagée la masse d'épreuve formant le corps d'épreuve 3. De préférence, la plaquette de silicium 3B, qui porte la masse d'épreuve formant le corps d'épreuve 3, est solidarisée par thermocompression à l'aide de surfaces métallisées, avec ou sans apport de métal de brasage, à ladite deuxième pièce de support 1000 qui forme avantageusement le capot 100. Dans le mode de réalisation particulier de la figure 9, lesdits capot 100 et embase 2 sont ainsi formés respectivement par la première pièce de support 2000 et la deuxième pièce de support 1000 toutes deux en verre ou en silicium. La plaquette de silicium 3B, qui porte la masse d'épreuve formant le corps d'épreuve 3, est avantageusement interposée entre lesdites première et deuxième pièces de support 2000, 1000 et solidarisée à ces dernières par thermocompression en périphérie, de façon à former un boîtier fermé (de préférence hermétique) délimitant une cavité qui accueille la masse d'épreuve portée par la plaquette de silicium 3B. Conformément au mode de réalisation de la figure 9, chaque électrode interne, comme par exemple l'électrode électriquement conductrice 70, est avantageusement connectée à au moins un puits métallisé de connexion électrique 71 ménagé dans la deuxième pièce de support 1000 formant en l'espèce le capot 100. De préférence, dans le cadre du mode de réalisation de la figure 9, le procédé comprend une étape d'encapsulation du boîtier formé en l'espèce par les première et deuxième pièces de support 2000, 1000 dans une enveloppe extérieure 80, formée par exemple par un support 80A, auquel est fixé le boîtier et un couvercle 80B attaché au support 80A pour coiffer le boîtier, comme illustré à la figure 9. Lesdits support 80A et couvercle 80B sont par exemple réalisés en matériau métallique ou en matériau céramique. Dans ce mode de réalisation, le logement 27 d'accueil de la carte électronique peut se trouver à l'intérieur de l'enveloppe extérieure 80, ou éventuellement à l'extérieur de cette dernière. Dans le mode de réalisation de la figure 9, l'électronique associée au logement 27 se trouve par exemple à l'intérieur de l'enveloppe extérieure 80 et pourra avantageusement être un ASIC (Application-Specific Integrated Circuit). L'électronique pourra communiquer avec des éléments électroniques complémentaires placés à l'extérieur de l'enveloppe extérieure 80, via une interconnexion par connecteur (non représenté sur la figure 9) traversant l'enveloppe extérieure 80. Il est à noter que chaque puits 71 peut aussi de manière similaire être réalisé dans la première pièce de support 2000, moyennant la mise en place d'un entrefer entre la première pièce de support 2000 et le support 80A, par exemple à l'aide de rehausses rajoutées ou par conception, pour éviter la mise en court-circuit de ces puits avec le support 80A.

Avantageusement, le procédé de fabrication comprend une étape de tirage au vide dans ledit boîtier formé par l'assemblage du capot 100 à l'embase 2, afin de placer l'intérieur dudit boîtier sous vide, et par exemple sous vide grossier (pression comprise entre la pression atmosphérique et 100 Pa), ou sous vide primaire (pression atmosphérique comprise entre 100 Pa et 0,1 Pa), ou encore sous vide secondaire (pression comprise entre 0,1 Pa et 10⁻⁶ Pa) voire sous ultravide (pression comprises entre 10^{- 6} Pa et 10⁻⁹ Pa) ou même éventuellement sous ultra-ultravide (pression inférieure à 10⁻⁹ Pa). Alternativement, ledit procédé comprend une étape de remplissage dudit boîtier par un gaz sec, afin que l'intérieur du boîtier soit rempli dudit gaz sec. Ledit gaz sec ne contient sensiblement pas de liquides ni de condensats. Il est par exemple formé par de l'azote (N₂), ou un gaz inerte, comme de l'argon (Ar). En général, la mise sous vide de l'enceinte contenant le corps d'épreuve vibrant, ou son remplissage par un gaz sec, aide à minimiser les perturbations externes, améliore la stabilité des mesures et prolonge la durabilité du capteur, grâce en particulier à la diminution de l'amortissement affectant par exemple l'amplitude et la stabilité des vibrations dans le cas où le corps d'épreuve 3 inclut un résonateur (figures 1 à 8), ou une poutre vibrante (figure 9). Dans le cas de la variante de la figure 9, le remplissage du volume intérieur du boîtier par un gaz sec peut être préférable au vide pour amortir les mouvements de la masse d'épreuve.

Par exemple, dans le mode de réalisation des figures 1 à 7, l'étape de tirage au vide s'effectue au moyen d'un tube d'aspiration d'air introduit à l'intérieur du boîtier, de préférence par un orifice d'aspiration ménagé à travers ladite paroi de fond 100C (en une zone de tirage au vide Z3) qui est ensuite (une fois terminée l'opération de tirage au vide) obturé. Un procédé de tirage au vide de principe analogue à celui décrit ci-avant pourra être mise en œuvre, avec les adaptations requises, pour le mode de réalisation de la figure 8, par exemple utilisant le principe d'un queusot métallique traversant l'embase 2 et pincé sous vide pour obtenir l'herméticité recherchée. On parle alors de « queusotage ». Concernant le mode de réalisation de la figure 9, l'assemblage de l'embase 2 au capot 100, tous deux en verre ou en silicium, sera avantageusement réalisé par thermocompression sous vide.

Le procédé de fabrication conforme à invention comprend en outre une étape de blindage magnétique du boîtier formé par l'embase 2 et le capot 100. Ladite étape de blindage inclut une première opération de dépôt, par galvanoplastie (que l'on peut également désigner par le terme « *électrodéposition* »), d'une première couche d'un premier matériau ferromagnétique sur une partie au moins dudit boîtier, afin de réduire la sensibilité du capteur inertiel mécanique vibrant 1 aux champs magnétiques externes, notamment basses fréquences, qui pourraient affecter la performance de mesure. La première opération de dépôt par galvanoplastie de ladite première couche consiste ainsi en une opération d'électrodéposition de la première couche, qui repose sur une technique de dépôt électrolytique permettant d'appliquer un dépôt métallique (en l'espèce ledit premier matériau ferromagnétique) à la surface d'un objet (en l'espèce au moins une partie du boîtier). Ladite opération d'électrodéposition (galvanoplastie) est avantageusement une opération d'électroplacage (« *electroplating* » en anglais), qui peut être éventuellement une opération d'électroplacage composite (« *electro-clad* » en anglais).

La galvanoplastie consiste, en général, à déposer de façon uniforme un métal sur une surface conductrice dans un bain de sel (électrolyte à base de sulfate, ou électrolyte de citrate pour une meilleure efficacité, ou encore électrolyte de chlorure pour des applications spéciales, *etc*.) via un courant électrique. L'électrodéposition (galvanoplastie) repose plus précisément sur le principe général suivant :
- l'objet cible à revêtir (par exemple en l'espèce le boîtier, ou une partie de celui-ci comme par exemple le capot 100 et/ou l'embase 2) est placé dans un bain contenant une solution d'électrolyte ;
- l'objet cible forme une cathode connectée à la borne négative d'une source de courant continu, tandis qu'une anode réalisée en le matériau à déposer est connectée à la borne positive et plongée elle aussi dans ledit bain ;
- l'application d'un courant électrique provoque la migration des ions métalliques de l'anode vers la cathode où ils se déposent et forment une couche métallique uniforme.

La galvanoplastie permet d'obtenir des vitesses de déposition élevées (par exemple pouvant être près de 100 fois supérieures à celles mises en œuvre par la technique de pulvérisation cathodique mentionnée précédemment).

La mise en œuvre d'un dépôt par une telle technique électrolytique permet de former un blindage magnétique au plus près du corps d'épreuve 3, sous la forme d'une couche de blindage magnétique qui peut épouser fidèlement la forme de l'élément sensible, et plus précisément du boîtier, permettant ainsi d'obtenir un blindage magnétique particulièrement efficace, sans avoir besoin de recourir comme dans l'art antérieur à une cage de blindage susceptible d'augmenter l'encombrement et la masse du capteur inertiel 1, avec en outre un risque de dégradation des propriétés de blindage de la cage lors de sa fabrication par mise en forme et assemblage de feuillets métalliques épais. Le recours à un blindage formé par une couche de matériau ferromagnétique directement électrodéposée sur au moins une partie de la surface de l'élément sensible, et plus précisément du boîtier, offre, en plus du blindage magnétique, des effets techniques et avantages particulièrement intéressants, comme en particulier :
- Amélioration de l'intégrité structurale et de l'étanchéité : en électrodéposant une couche de matériau ferromagnétique directement sur la surface de l'élément sensible, et plus précisément du boîtier, notamment sur la paroi du capot 100, la robustesse et la durabilité de l'élément sensible, et en particulier du capot 100, sont améliorés. Il s'agit là d'un effet synergique : en plus de conduire à l'obtention d'un blindage électromagnétique, le dépôt de la couche du matériau ferromagnétique par galvanoplastie renforce mécaniquement l'élément sensible, et plus précisément le boîtier, et notamment le capot 100. La mise en œuvre d'une couche de blindage magnétique électrodéposée permet en outre de bénéficier d'une barrière d'étanchéité supplémentaire, améliorant ainsi l'intégrité du vide interne à l'élément sensible.
- Réduction de la complexité de fabrication et des coûts : l'utilisation de la galvanoplastie pour déposer une couche de matériau ferromagnétique simplifie le processus de fabrication en éliminant la nécessité de fabriquer et d'assembler des cages de blindage distinctes. Ceci permet de réduire les coûts de production et accélérer le processus d'assemblage.
- Minimisation de l'encombrement : en incorporant la protection électromagnétique directement à l'élément sensible, en l'espèce au boîtier, on réduit l'espace nécessaire pour le blindage externe, ce qui est particulièrement avantageux pour les applications où l'espace est limité.

- Amélioration de l'efficacité du blindage : la galvanoplastie permet de déposer un revêtement uniforme et continu, pour autant que la pièce à revêtir ne présente pas de rayons trop aigus (inférieurs à 0,2 mm par exemple - cette exigence peut être prise en compte lors de la conception de l'élément sensible), offrant ainsi potentiellement une couverture particulièrement homogène et efficace contre les interférences électromagnétiques.
- Réduction des gradients thermiques : les différences de température et les gradients thermiques dans et autour dudit élément sensible, et plus précisément dudit boîtier au sein duquel est logé le corps d'épreuve 3 peuvent causer des anisotropies des paramètres physiques dégradant la performance du capteur inertiel mécanique vibrant dues à l'expansion ou à la contraction non uniforme du corps d'épreuve 3. Un revêtement de blindage déposé par galvanoplastie peut, en plus de sa fonction de protection contre les interférences électromagnétiques, aider à homogénéiser la réponse thermique du boîtier, améliorant la stabilité thermique du capteur inertiel mécanique vibrant.

En définitive, le dépôt direct d'un matériau ferromagnétique de blindage sur au moins une partie du boîtier (i.e. sur au moins une partie du capot 100 et/ou de l'embase 2) qui englobe le corps d'épreuve 3 permet notamment une minimisation de la masse et de l'encombrement par rapport aux solutions conventionnelles de blindage, une augmentation de la robustesse et de la durabilité, ainsi qu'une performance de mesure particulièrement améliorée et plus stable. Le recours à une telle opération de dépôt par galvanoplastie directement sur le boîtier permet en outre au procédé de fabrication d'être particulièrement rapide et bon marché, ladite première opération de dépôt par galvanoplastie pouvant en outre s'intégrer de façon astucieuse dans le procédé global de fabrication de l'élément sensible, comme cela ressortira de ce qui suit.

Optionnellement, le procédé inclut une opération préalable de traitement de la surface de l'élément sensible, et plus précisément du boîtier, à revêtir par galvanoplastie, avant la première opération de dépôt par galvanoplastie de la première couche. Ladite opération préalable de traitement inclut par exemple le dépôt, sur ladite surface du boîtier à revêtir, d'une couche d'accrochage (par exemple contenant du cuivre). Dans le cas où la paroi de l'élément sensible, et plus précisément du boîtier, recouverte par la première couche du premier matériau ferromagnétique, est métallique, ladite première couche peut être déposée directement par galvanoplastie sur la paroi métallique du boîtier (modes de réalisation des figures 1 à 8), sans pour autant déposer au préalable une couche d'accrochage. Le recours à une telle couche d'accrochage peut s'avérer néanmoins préférable même dans ce cas où la surface à revêtir est métallique. Dans le cas où la paroi du boîtier à revêtir par galvanoplastie n'est pas métallique, et est par exemple en verre ou en silicium comme dans le mode de réalisation de la figure 9, le procédé inclut de préférence ladite opération préalable de traitement de la surface de l'élément sensible (et plus précisément du boîtier) à revêtir par galvanoplastie, avant dépôt par galvanoplastie de la première couche, sous la forme par exemple d'un dépôt, sur ladite surface du boîtier à revêtir, de ladite couche d'accrochage (par exemple un alliage nickel-or contenant du cuivre) qui adhère à la paroi en verre ou en silicium du boîtier et sur laquelle est ensuite déposé par galvanoplastie la première couche du premier matériau ferromagnétique.

Avantageusement, ledit premier matériau ferromagnétique de la première couche est un matériau à structure nanocristalline. Ladite structure nanocristalline présente par exemple une taille moyenne de grains comprise entre 5 et 100 nm, de préférence comprise entre 5 et 50 nm, de façon encore plus préférentielle entre 10 et 30 nm. Le recours à une telle structure nanocristalline permet de conférer à ladite première couche une perméabilité magnétique élevée, qui permet un excellent effet de blindage magnétique, en particulier vis-à-vis des champs magnétiques externes de basse fréquence (par exemple inférieure à 1 MHz), tout en assurant un blindage à large spectre. Ceci permet de minimiser l'épaisseur de ladite première couche tout en conservant une performance de blindage optimale. En outre, le recours à un matériau à structure nanocristalline permet de conférer à ladite première couche une dureté et une résistance mécanique particulièrement élevées, ce qui rend la première couche particulièrement robuste, fiable et durable.

Avantageusement, ledit premier matériau ferromagnétique de la première couche présente une coercivité basse, de préférence inférieure à 80 A/m, de façon encore plus préférentielle inférieure à 70 A/m, par exemple comprise entre 20 et 70 A/m, préférentiellement inférieure à 10 A/m, et encore plus préférentiellement inférieure à 3 A/m. Le corollaire de ce niveau de coercivité relativement faible est un niveau relativement élevé de perméabilité magnétique. Ainsi, le premier matériau ferromagnétique présente avantageusement une perméabilité magnétique relative maximum au moins égale à 4 500, de préférence au moins égale à 5 000 voire même 8 000, par exemple comprise entre 5 000 et 50 000, de façon encore plus préférentielle au moins égale à 40 000, et pouvant même aller au-delà de 90 000, de sorte que le premier matériau ferromagnétique présente des caractéristiques de blindage magnétique à basse fréquence qui sont excellentes.

Avantageusement, ledit premier matériau ferromagnétique de ladite première couche présente une magnétisation à saturation comprise entre 0,6 et 1,5 T, de préférence entre 0,9 et 1,1 T. Grâce à ce niveau de magnétisation à saturation, la première couche assure un blindage électromagnétique optimal, étant entendu qu'une magnétisation à saturation élevée est généralement associé à une perméabilité magnétique élevée, qui permet au matériau de conduire plus facilement les lignes de champ magnétique, ce qui améliore son efficacité de blindage, y compris en présence de champs magnétiques externes intenses.

Avantageusement, ledit premier matériau ferromagnétique présente une rémanence comprise entre 0,1 et 1T, de préférence comprise entre 0,3 et 0,8 T. Un tel niveau de rémanence permet là encore d'optimiser le blindage électromagnétique, en permettant de faire en sorte que la première couche ne devienne pas elle-même une source de perturbation magnétique significative une fois le champ externe supprimé. Il est ainsi possible, grâce au niveau préférentiel de rémanence précité, de bénéficier de propriétés de blindage particulièrement stables, même après exposition à des champs magnétiques externes intenses.

Les valeurs des paramètres précités (perméabilité magnétique, magnétisation à saturation, coercivité, rémanence...) sont déterminées par des mesures standard, menées par exemple selon la norme ASTM A773 de 2021, à partir par exemple de tracés de cycles d'hystérésis B-H.

Avantageusement, ledit premier matériau ferromagnétique inclut du nickel, et de préférence est un alliage nickel-fer, avec par exemple un pourcentage massique compris entre 45 et 80 % pour le nickel et entre 15 et 55 % pour le fer. Le recours à un alliage nickel-fer permet en particulier d'atteindre, de préférence lorsqu'est mis en œuvre une structure nanocristalline, d'excellentes propriétés magnétiques, correspondant aux différentes plages de paramètres évoqués précédemment, ce qui permet un blindage électromagnétique très performant, y compris lorsque la première couche présente une épaisseur bien inférieure à l'épaisseur des feuillets de blindage mis en œuvre dans l'art antérieur pour former des cages de blindage. De préférence, ledit alliage Ni-Fe inclut en outre du molybdène Mo (par exemple à hauteur de 5 % au plus en masse) et du manganèse Mn (par exemple à hauteur de moins de 1 % en masse).

Par exemple, la première couche présente une épaisseur inférieure à 350 µm, de préférence inférieure à 300 µm, de façon encore plus préférentielle comprise entre 50 et 250 µm, par exemple comprise entre 100 et 200 µm. Le recours à une telle épaisseur conduit, avantageusement en combinaison avec les autres caractéristiques précitées, à un effet de blindage particulièrement efficace, sans trop alourdir le capteur inertiel mécanique vibrant 1.

Avantageusement, le matériau ferromagnétique présente une masse volumique qui est comprise entre 8 et 9 g/cm³, de préférence comprise entre 8,4 et 8,8 g/cm³, ce qui la situe au niveau de celle des alliages classiquement utilisés en feuillets pour former des cages de blindage.

Avantageusement, au cours de ladite première opération de dépôt, ladite première couche du premier matériau ferromagnétique est électrodéposée sur une partie au moins dudit capot 100 et/ou sur une partie au moins de ladite embase 2. En d'autres termes, la première opération de dépôt peut consister :
- à électrodéposer la première couche sur une partie au moins du capot 100, au cours d'une première sous-opération de dépôt par galvanoplastie de la première couche sur le capot 100 ; et/ou
- à électrodéposer la première couche sur une partie au moins de l'embase 2, au cours d'une deuxième sous-opération de dépôt par galvanoplastie de la première couche sur l'embase 2,
lesdites première et deuxième sous-opérations de dépôt de la première couche pouvant être effectuées ensemble ou séparément.

Avantageusement, au cours de ladite première opération de dépôt, et plus précisément au cours de ladite première sous-opération de dépôt, ladite première couche est électrodéposée sur le capot 100, de préférence sur une seule des faces interne 110 et externe 120 du capot 100. De préférence, ladite première couche du premier matériau ferromagnétique est électrodéposée sur au moins une portion de la face externe 120 au cours de ladite première opération de dépôt. De préférence, ladite première couche est déposée sur la face externe 120 mais pas sur la face interne 110. Il s'avère en effet que le dépôt de la première couche seulement sur l'une des faces du capot 100 est suffisant pour obtenir l'effet de blindage recherché. En outre, il suffit de placer un couvercle de masquage sur et contre le bord 100B (modes de réalisation des figures 1 à 8) pour empêcher l'électrodéposition d'une couche de matériau ferromagnétique sur la face interne 110, ce qui facilite la mise en œuvre de la première opération de dépôt, par rapport à un recouvrement uniquement de la face interne et non de la face externe.

Par exemple, la première opération de dépôt est effectuée avant l'étape d'assemblage du capot 100 à l'embase 2, de sorte que la première opération de dépôt de la première couche s'effectue sur le capot 100 et/ou l'embase 2 alors que le capot 100 est séparé de l'embase 2, ce qui permet de faciliter la première opération de dépôt et d'en optimiser la qualité. Il est cependant parfaitement envisageable que la première opération de dépôt s'effectue après formation du boîtier par assemblage du capot 100 et de l'embase 2.

Conformément aux modes de réalisation des figures 1 à 8, la première couche du premier matériau ferromagnétique est électrodéposée, au cours de ladite première opération de dépôt, sur toute la paroi latérale cylindrique 100A du capot 100, sur la face externe 120, sauf en ladite zone terminale Z2, grâce par exemple à un masquage temporaire déposé sur la zone terminale Z2 pour empêcher le dépôt de la première couche du matériau ferromagnétique sur la zone terminale Z2. Dans les modes de réalisation des figures 1 à 8, l'absence de la première couche au niveau de la zone terminale Z2 permet de faciliter et fiabiliser ladite opération de soudage ou brasage, permettant ainsi audit cordon de soudure ou brasure reliant l'embase 2 à la zone terminale Z2 d'adhérer directement au matériau formant le capot 100, sans interposition entre le cordon et ledit capot 100 de la première couche, qui pourrait nuire à l'adhésion et à la fiabilité dudit cordon de soudure ou brasure. Pour une raison analogue, ladite première couche est avantageusement électrodéposée, au cours de ladite première opération de dépôt, sur toute la paroi de fond 100C du capot 100, sur la face externe 120, sauf en une zone de tirage au vide Z3 au niveau de laquelle est destiné à être réalisé ledit orifice d'aspiration à travers la paroi de fond 100C, ladite zone de tirage au vide Z3 étant destinée à recevoir ensuite ledit plot de soudure ou brasure qui obture l'orifice d'aspiration. Ainsi, ledit plot de soudure ou brasure adhère directement au matériau formant le capot 100, sans interposition de la première couche qui pourrait nuire à l'adhésion et à la robustesse dudit plot de soudure ou brasure.

Avantageusement, au cours de ladite première opération de dépôt, et plus précisément au cours de ladite deuxième sous-opération de dépôt, ladite première couche est électrodéposée sur une partie au moins de ladite embase 2. De préférence, la première couche est uniforme, c'est-à-dire que les caractéristiques de la première couche sont constantes sur toute la surface recouverte, qu'il s'agisse de la surface de l'embase 2 ou de celle du capot 100. Cela signifie que la composition, les propriétés physico-chimiques (notamment magnétiques), la structure et l'épaisseur de la première couche sont avantageusement partout les mêmes à la surface de l'élément sensible, et plus précisément du boîtier.

Avantageusement, ladite deuxième sous-opération de dépôt de la première couche sur l'embase 2 est effectuée avant ladite étape d'assemblage du capot 100 à ladite embase 2. Ainsi, la première couche dudit premier matériau ferromagnétique peut être électrodéposée sur l'embase 2 prise séparément, avant son assemblage avec le capot 100, ce qui peut faciliter la mise en œuvre du procédé de fabrication. Eventuellement, ladite deuxième sous-opération de dépôt est effectuée avant l'étape d'association du corps d'épreuve 3 à l'embase 2, ce qui peut permettre, notamment dans les modes de réalisation des figures 1 à 8, de simplifier et fiabiliser le procédé de fabrication.

Par exemple, ladite première couche est électrodéposée, au cours de ladite première opération de dépôt, sur toute l'embase 2, sauf en au moins une portion de cette dernière qui est destinée à se trouver à l'intérieur du boîtier et qui inclut ladite zone de fixation Z1 (modes de réalisation des figures 1 à 8). Par exemple, ladite portion qui inclut ladite zone de fixation Z1 est recouverte d'un masque provisoire durant ladite deuxième sous-opération de dépôt par galvanoplastie de la première couche, afin de ne pas être recouverte par ladite première couche. Le masque provisoire peut simplement consister en une pellicule de protection adhésive, qui empêche l'électroplacage de la zone concernée, puis peut être retirée après que la deuxième sous-opération de dépôt est terminée. Ceci permet de favoriser une fixation particulièrement fiable et durable du corps d'épreuve 3 à l'embase 2, par exemple par soudage ou brasage (figures 1 à 8), ou thermocompression (figure 9), en évitant l'interposition entre le matériau de l'embase 2 et celui du pied central 30 ou de la plaquette de silicium 3B, de la première couche du premier matériau ferromagnétique, qui pourrait perturber l'assemblage par brasage ou soudage du pied 30 à l'embase 2 (figures 1 8), ou par thermocompression de la plaquette de silicium 3B à l'embase 2 (figure 9).

Avantageusement, la première couche de matériau ferromagnétique ne recouvre pas les tiges électriquement conductrices 40, 41, 42, 43, 44, 45, 46, 47, 60, 61, 62 (ainsi que celles non représentées aux figures mais qui se déduisent de celles précitées par symétrie) afin précisément de ne pas altérer la performance des opérations ultérieures de soudure de ces tiges à des éléments électroniques ou de la connectique. À cette fin, lesdites tiges 40, 41, 42, 43, 44, 45, 46, 47, 60, 61, 62 (ainsi que celles non représentées aux figures mais qui se déduisent de celles précitées par symétrie) sont préférentiellement recouvertes d'un masque provisoire durant ladite première opération de dépôt (et plus précisément durant ladite deuxième sous-opération de dépôt), afin de ne pas être recouvertes par ladite première couche de matériau ferromagnétique. Le masque provisoire peut par exemple se présenter sous la forme d'un élément adhésif pelable qui empêche l'électroplacage des tiges conductrices lors de la première opération de dépôt par galvanoplastie, tant en ce qui concerne la portion des tiges qui est destinée à saillir à l'intérieur du boîtier que celle qui est destinée à saillir à l'extérieur du boîtier.

Dans les modes de réalisation particuliers des figures 1 à 8, la première opération de dépôt de la première couche du premier matériau ferromagnétique inclut ainsi par exemple :
- la première sous-opération de dépôt, par galvanoplastie, de la première couche du premier matériau ferromagnétique sur sensiblement toute la face externe 120 du capot 100, à l'exception de la zone terminale Z2 et de la zone de tirage au vide Z3 ;
- la deuxième sous-opération de dépôt, par galvanoplastie, de la première couche dudit premier matériau ferromagnétique sur l'embase 2, à l'exception de ladite portion incluant la zone de fixation Z1, tout en faisant en sorte d'éviter que les tiges électriquement conductrices 40, 41, 42, 43, 44, 45, 46, 47, 60, 61, 62 (ainsi que celles non représentées aux figures mais qui se déduisent de celles précitées par symétrie) ne soient recouvertes par ladite première couche, si lesdites tiges ont été préalablement associées à l'embase 2, avant la deuxième sous-opération de dépôt ; de préférence, la première couche présente une épaisseur uniforme, identique sur le capot 100 et l'embase 2, par exemple comprise entre 50 et 250 µm, et met en œuvre le même premier matériau ferromagnétique partout, qui est de préférence un alliage nickel-fer, par exemple à structure nanocristalline.
- l'étape de fixation du résonateur 3A à l'embase 2, par exemple par soudage ou brasage ;
- l'étape d'assemblage du capot 100 à l'embase 2, par exemple par brasage ou soudage ;
- l'étape de tirage au vide par aspiration de l'air contenu dans le boîtier, via un orifice ménagé à travers le capot 100, qui est ensuite immédiatement obturé, par exemple par un plot de soudure ou brasure.

À l'issue du procédé, on obtient un capteur inertiel mécanique vibrant 1 muni d'un blindage électromagnétique particulièrement performant, notamment vis-à-vis de champs électromagnétiques externes de basses fréquences.

Dans le mode de réalisation de la figure 9, où le boîtier est logé au sein d'une enveloppe extérieure 80 fermée, au-delà des étapes précédentes de galvanoplastie de l'embase 2 et du capot 100, ladite étape de blindage magnétique du boîtier inclut avantageusement une opération primaire de dépôt, par galvanoplastie, d'une couche primaire dudit premier matériau ferromagnétique sur une partie au moins de ladite enveloppe extérieure 80, et par exemple sur toute la surface externe de l'enveloppe extérieure 80, formée par l'assemblage du support 80A et du couvercle 80B. Ceci permet d'obtenir un blindage magnétique optimal, par combinaison de la première couche de matériau ferromagnétique déposée sur le boîtier formé par l'assemblage de l'embase 2 et du capot 100, et de la couche primaire de matériau ferromagnétique déposée sur l'enveloppe extérieure 80. Ladite opération primaire de dépôt par galvanoplastie de la couche primaire sur l'enveloppe extérieure 80 peut être précédée d'une opération de dépôt d'une couche d'accrochage sur la surface à revêtir de l'enveloppe extérieure 80, notamment si cette dernière est réalisée en un matériau céramique comme envisagé précédemment.

Afin d'améliorer encore les performances de blindage, tout en préservant la compacité et la légèreté du capteur inertiel 1, ladite étape de blindage magnétique inclut avantageusement :
- une deuxième opération de dépôt, de préférence par galvanoplastie, d'une deuxième couche d'un deuxième matériau diamagnétique ou paramagnétique, par exemple à base de cuivre qui permet en outre de mieux conduire la chaleur et d'optimiser la réduction des gradients de température au niveau de l'élément sensible, sur ladite première couche du premier matériau ferromagnétique, et
- une troisième opération de dépôt, par galvanoplastie, d'une troisième couche d'un troisième matériau ferromagnétique, sur ladite deuxième couche du deuxième matériau diamagnétique ou paramagnétique.

Dans ce mode de réalisation préférentiel, le procédé selon l'invention conduit à la réalisation d'un blindage multicouches, formé par l'empilement d'au moins la première couche, la deuxième couche et la troisième couche.

Un tel agencement s'avère particulièrement intéressant car il conduit à un blindage magnétique plus performant que celui obtenu avec une couche de même épaisseur formée uniquement du premier matériau ferromagnétique. Il a en effet été identifié que lorsqu'une couche homogène de matériau ferromagnétique d'épaisseur donnée est mise en œuvre à des fins de blindage magnétique de l'élément sensible du capteur inertiel mécanique vibrant 1, seule une portion de l'épaisseur de cette couche dévie en réalité efficacement les lignes de champ magnétique. Il s'avère ainsi plus intéressant de mettre en œuvre une pluralité de couches de matériaux ferromagnétiques de moindre épaisseur séparées entre elles par une couche de matériau diamagnétique ou paramagnétique. De préférence, la deuxième couche du deuxième matériau diamagnétique ou paramagnétique présente une épaisseur comprise entre 50 et 400 µm, de préférence comprise entre 50 et 300 µm, par exemple d'environ 100 µm.

Par exemple, lesdites deuxième et troisième opérations de dépôt sont effectuées avant ladite étape d'assemblage dudit capot 100 à ladite embase 2 (comme par exemple dans les modes de réalisation des figures 1 à 8).

Le troisième matériau ferromagnétique est quant à lui avantageusement identique au premier matériau ferromagnétique, de sorte que la troisième opération de dépôt consiste dans ce cas-là à déposer une troisième couche du premier matériau ferromagnétique sur ladite deuxième couche. Avantageusement, la troisième couche présente une épaisseur inférieure à 350 µm, de préférence inférieure à 300 µm, de façon encore plus préférentielle comprise entre 50 et 250 µm, par exemple comprise entre 100 et 200 µm. Dans un exemple de réalisation particulièrement avantageux, la première couche est formée d'un premier matériau ferromagnétique constitué d'un alliage nickel-fer avec par exemple un pourcentage massique de nickel compris entre 45 et 79 % et un pourcentage massique de fer compris entre 15 et 55 %, et inclut en outre du molybdène Mo (5 % au plus en masse) et du manganèse Mn (moins de 1 % en masse). L'épaisseur de la première couche est par exemple d'environ 150 µm. La troisième couche est quant à elle sensiblement identique à la première couche, c'est-à-dire qu'elle est formée du même matériau ferromagnétique évoqué ci-avant et présente une épaisseur similaire de 150 µm. Enfin, la deuxième couche est formée de préférence d'un matériau diamagnétique, par exemple du cuivre ou un alliage de cuivre qui permet en outre de mieux conduire la chaleur et d'optimiser la réduction des gradients de température au niveau de l'élément sensible. On obtient ainsi un blindage tri-couches d'épaisseur totale sensiblement égale à 0,5 mm, dont les performances de blindage sont supérieures à celle d'une couche qui serait formée uniquement du même matériau ferromagnétique que celui des première et troisième couches et qui présenterait une même épaisseur totale de 0,5 mm. Il est ainsi possible, dans ce mode de réalisation particulier, d'optimiser l'efficacité du blindage pour une même épaisseur maximale donnée.

Avantageusement, les deuxième et troisième opérations de dépôt sont répétées en alternance pour former un empilement de couches alternées de matériau ferromagnétique et de matériau diamagnétique ou paramagnétique, pour former ainsi un empilement de couches électrodéposées de matériau ferromagnétique séparées entre elles par des couches électrodéposées de matériau diamagnétique ou paramagnétique. L'invention met ainsi avantageusement en œuvre un revêtement uniforme en surface du boîtier, qui peut être soit une simple couche (monocouche) d'un matériau ferromagnétique, déposé par galvanoplastie, soit un empilement de couches alternées de matériau ferromagnétique et diamagnétique (ou paramagnétique), toutes déposées par galvanoplastie, afin de former un blindage multicouche.

Comme rappelé précédemment, l'invention concerne également en tant que tel un capteur inertiel mécanique vibrant 1 susceptible d'être fabriqué par un procédé selon la description qui précède, ledit capteur inertiel mécanique vibrant 1 comprenant au moins une embase 2, un corps d'épreuve 3 attaché à l'embase 2 et conçu pour vibrer et/ou se déformer et/ou se déplacer, par exemple globalement ou localement, ainsi qu'un capot 100 qui coiffe le corps d'épreuve 3 et forme avec l'embase 2 un boîtier qui délimite un espace intérieur au sein duquel est logé le corps d'épreuve 3, ledit espace intérieur étant placé sous vide ou étant rempli par un gaz sec, ledit boîtier étant au moins en partie revêtue par une première couche d'un premier matériau ferromagnétique déposé par galvanoplastie, pour former un blindage magnétique dudit boîtier.

Comme exposé précédemment, le capteur inertiel mécanique vibrant 1 forme avantageusement un capteur gyroscopique vibrant (figures 1 à 8), ledit corps d'épreuve 3 étant dans ce cas formé par un résonateur 3A, lequel comprend par exemple un cylindre vibrant 31 (figures 1 à 7) ou une coque hémisphérique vibrante 32 (figure 8).

Dans un autre mode de réalisation, le capteur inertiel mécanique vibrant 1 forme un accéléromètre à poutres vibrantes (VBA) de type système microélectronique (MEMS), auquel cas le corps d'épreuve 3 est avantageusement formé par une masse d'épreuve qui est par exemple réalisée par micro-usinage d'une plaquette de silicium ou de quartz 3B. Dans ce dernier mode de réalisation, le capteur inertiel mécanique vibrant 1 comprend préférentiellement, comme exposé précédemment en relation avec le procédé, une enveloppe extérieure 80 au sein de laquelle est encapsulé le boîtier, comme illustré à la figure 9. Ladite enveloppe extérieure 80 est au moins en partie revêtue dans ce cas par une couche primaire dudit premier matériau ferromagnétique déposée par galvanoplastie, pour optimiser le blindage magnétique, avec éventuellement une couche d'accrochage interposée entre l'enveloppe extérieure 80 et la couche primaire pour favoriser la tenue de cette dernière sur l'enveloppe extérieure 80, notamment si cette dernière est réalisée en un matériau céramique par exemple. Ainsi, dans le mode de réalisation particulier de la figure 9, le capteur inertiel mécanique vibrant 1 comprend préférentiellement un boîtier au moins en partie revêtu par une première couche d'un premier matériau ferromagnétique déposé par galvanoplastie, ainsi qu'une enveloppe extérieure 80 au sein de laquelle est encapsulé le boîtier, laquelle enveloppe extérieure 80 est elle aussi avantageusement revêtue par le premier matériau ferromagnétique déposé par galvanoplastie.

L'invention concerne enfin également en tant que telle une centrale inertielle qui inclut au moins une platine 4 ainsi qu'au moins un capteur inertiel mécanique vibrant 1 selon l'invention. Ladite platine 4 est pourvue d'au moins un support 50 auquel est fixé ledit capteur inertiel mécanique vibrant 1 pour être immobilisé par rapport à ladite platine 4. Par exemple, dans le mode de réalisation illustré aux figures, le support 50 se présente sous la forme d'une partie monolithique prolongeant la platine 4 ou d'une bague attachée à la platine 4 et dans laquelle est enfilé le capot 100 d'un capteur inertiel mécanique vibrant 1. La bague formant le support 50 peut par exemple comprendre en outre des orifices de fixation 500, 501, 502, 503 venant en correspondance respective avec les orifices ménagés par les oreilles de fixation 200, 210, 220, 230 (mode de réalisation des figures 1 à 7), pour permettre par exemple une fixation de l'embase 2 au support 50 par vissage. Avantageusement, la platine est pourvue, en plus du support 50, de deux autres supports 51, 52 qui lui sont similaires et auxquels sont attachées respectivement deux autres capteurs inertiels mécaniques vibrants selon l'invention. Lesdits supports 50, 51, 52 sont disposés perpendiculairement les uns par rapport aux autres selon respectivement les trois directions de l'espace, de telle sorte que les trois capteurs inertiels mécaniques vibrants selon l'invention embarqués par la centrale inertielle sont disposés pour que leur axe central Z-Z' respectif s'étende selon une direction de l'espace perpendiculaire aux deux autres directions de l'espace. De préférence, la centrale inertielle selon l'invention accueille, en plus de trois capteurs gyroscopiques vibrants selon l'invention, par exemple conforme au mode de réalisation des figures 1 à 7, trois accéléromètres à poutres vibrantes (VBA) conformes à l'invention, par exemple conforme au mode de réalisation de la figure 9, lesdits accéléromètres étant disposés respectivement selon les trois directions de l'espace.

La centrale inertielle inclut en outre un couvercle 5 qui coiffe ledit au moins un capteur inertiel mécanique vibrant 1 (et pour un système de navigation, au moins six capteurs inertiels mécaniques vibrants disposés perpendiculairement les uns par rapport aux autres et assurant les fonctions de mesures accélérométriques et gyroscopiques selon un trièdre orthogonal ) et est attaché à la platine 4, par exemple par vissage, pour former avec cette dernière un coffret au sein duquel est logé ledit au moins un capteur inertiel mécanique vibrant 1 (en l'espèce les six capteurs inertiels mécaniques vibrants). Ledit coffret est au moins en partie revêtu par une couche secondaire dudit premier matériau ferromagnétique déposée par galvanoplastie. De préférence la couche secondaire est déposée par galvanoplastie de la même manière et selon un procédé identique à celui mis en œuvre pour déposer ladite première et/ou ladite troisième couche. Ladite couche secondaire est de préférence sensiblement similaire à ladite première et/ou à ladite troisième couche, tant dans son épaisseur que dans sa microstructure et ses caractéristiques physico-chimiques, et notamment ses caractéristiques magnétiques. Ainsi, l'invention permet de cumuler un double blindage, à savoir celui directement déposé sur chaque capteur inertiel mécanique vibrant 1 de la centrale inertielle, et celui directement déposé sur le coffret de la centrale inertielle, ce qui permet d'obtenir une performance de blindage excellente tout en conservant un encombrement et une masse maîtrisés, ainsi qu'un procédé de fabrication et d'assemblage facile, rapide et bon marché.

Il est également tout à fait envisageable de déposer sur la couche secondaire une couche tertiaire d'un matériau diamagnétique ou paramagnétique, par exemple par galvanoplastie, et de déposer ensuite sur cette couche tertiaire, là encore de préférence par galvanoplastie, une couche quaternaire d'un quatrième matériau ferromagnétique, qui est par exemple identique au premier matériau ferromagnétique. Il est ainsi formé un empilement de couches qui présentent les mêmes avantages que ceux déjà exposés dans ce qui précède en relation avec la description du procédé de fabrication.

Avantageusement, la platine 4 présente une face intérieure 4A qui porte le support 50 et se trouve en regard de l'intérieur du coffret, ainsi qu'une face extérieure 4B opposée, tandis que le couvercle 5 présente quant à lui une face intérieure 5A disposée en regard de l'intérieur du coffret, et donc en regard de la face intérieure 4A de la platine 4, et une face extérieure 5B opposée. Avantageusement, ladite couche secondaire est électrodéposée sur la face intérieure de la platine 4, ainsi que de préférence sur chaque support 50, 51, 52, afin de former un blindage situé au plus près de chaque capteur inertiel 1 monté à l'intérieur du coffret. Ladite couche secondaire n'est en revanche pas déposée sur la face extérieure 4B de la platine 4, afin de ne pas être exposée à un risque de dégradation mécanique, chimique ou thermique provenant de l'environnement extérieur. De la même façon, ladite couche secondaire est avantageusement déposée sur la face intérieure 5A du couvercle 5, mais pas sur sa face extérieure 5B, ce qui permet là encore de placer la couche de blindage au plus près de chaque capteur inertiel mécanique vibrant 1 contenu dans le coffret, en évitant que la couche secondaire ne soit exposée directement à l'environnement extérieur et aux risques de dégradation qui en découlent.

## Revendications

1. Procédé de fabrication d'un capteur inertiel mécanique vibrant (1), comprenant une étape d'association d'un corps d'épreuve (3) à une embase (2), ledit corps d'épreuve (3) étant conçu pour vibrer et/ou se déformer et/ou se déplacer, ledit procédé comprenant en outre une étape d'assemblage d'un capot (100) à ladite embase (2) pour que ledit capot (100) coiffe le corps d'épreuve (3) et forme avec l'embase (2) un boîtier au sein duquel est logé ledit corps d'épreuve (3), une étape de tirage au vide dans ledit boîtier ou de remplissage dudit boîtier par un gaz sec, le procédé étant **caractérisé en ce qu'**il comprend une étape de blindage magnétique dudit boîtier qui inclut une première opération de dépôt, par galvanoplastie, d'une première couche d'un premier matériau ferromagnétique sur une partie au moins dudit boîtier.

2. Procédé selon la revendication précédente **caractérisé en ce que** ledit premier matériau ferromagnétique est un matériau à structure nanocristalline, ladite structure nanocristalline présentant de préférence une taille moyenne de grain comprise entre 5 et 100 nm, de préférence comprise entre 5 et 50 nm, de façon encore plus préférentielle entre 10 et 30 nm.

3. Procédé selon l'une quelconque des revendications précédentes **caractérisé en ce que** ledit premier matériau ferromagnétique inclut du nickel, ledit premier matériau ferromagnétique étant de préférence un alliage nickel-fer, avec par exemple un pourcentage massique compris entre 45 et 80 % pour le nickel et entre 15 et 55 % pour le fer.

4. Procédé selon l'une quelconque des revendications précédentes **caractérisé en ce que** ladite première couche présente une épaisseur inférieure à 350 µm, de préférence inférieure à 300 µm, de façon encore plus préférentielle comprise entre 50 et 250 µm, par exemple comprise entre 100 et 200 µm.

5. Procédé selon l'une quelconque des revendications précédentes **caractérisé en ce que** ledit premier matériau ferromagnétique présente une perméabilité magnétique relative maximum au moins égale à 4 500, de préférence au moins égale à 5 000, de façon encore plus préférentielle au moins égale à 8 000, par exemple au moins égale à 40 000 et/ou ledit premier matériau ferromagnétique présente une magnétisation à saturation comprise entre 0,6 et 1,5 T, de préférence entre 0,9 et 1,1 T et/ou ledit premier matériau ferromagnétique présente une coercivité inférieure à 80 A/m, de préférence inférieure à 70 A/m, de façon encore plus préférentielle inférieure à 10 A/m, avantageusement inférieure à 3 A/m et/ou ledit premier matériau ferromagnétique présente une rémanence comprise entre 0,1 et 1 T, de préférence comprise entre 0,3 et 0,8 T.

6. Procédé selon l'une quelconque des revendications précédentes **caractérisé en ce que** ladite première opération de dépôt est effectuée avant ladite étape d'assemblage dudit capot (100) à ladite embase (2).

7. Procédé selon l'une quelconque des revendications précédentes **caractérisé en ce que** ledit capot (100) présente une face interne (110) destinée à se trouver en regard de l'intérieur du boîtier et une face externe (120) opposée, ladite première couche du premier matériau ferromagnétique étant électrodéposée sur au moins une portion de ladite face externe (120) au cours de ladite première opération de dépôt, ladite première couche étant de préférence électrodéposée sur ladite face externe (120) mais pas sur ladite face interne (110).

8. Procédé selon la revendication précédente **caractérisé en ce que** ledit capot (100) présente une forme de cloche avec une paroi latérale cylindrique (100A) présentant un bord libre (100B), ladite étape d'assemblage du capot (100) à l'embase (2) incluant une opération d'accostage pour que ledit bord libre (100B) vienne au contact de ladite embase (2) et une opération de soudage ou brasage pour réaliser un cordon de soudure ou brasure reliant l'embase (2) à une zone terminale (Z2) de la paroi latérale cylindrique (100A) située au voisinage du bord libre (100B) sur la face externe (120), ladite première couche étant électrodéposée, au cours de ladite première opération de dépôt, sur toute la paroi latérale cylindrique (100A), sur la face externe (120), sauf en ladite zone terminale (Z2).

9. Procédé selon l'une quelconque des revendications précédentes **caractérisé en ce que** ledit capteur inertiel mécanique vibrant (1) est un capteur gyroscopique vibrant, ledit corps d'épreuve étant formé par un résonateur (3A), ledit résonateur (3A) comprenant par exemple un cylindre vibrant (31) ou une coque hémisphérique vibrante (32) et **en ce qu'**il comprend de préférence une étape d'association d'au moins un dispositif d'excitation audit résonateur (3A) pour l'exciter en vibration, ainsi qu'une étape d'association d'au moins un dispositif de détection audit résonateur (3A) pour détecter des vibrations dudit résonateur (3A).

10. Procédé selon l'une quelconque des revendications 1 à 8 **caractérisé en ce que** ledit capteur inertiel mécanique vibrant (1) est un accéléromètre à poutres vibrantes (VBA), par exemple de type système microélectromécanique (MEMS), ledit corps d'épreuve (3) étant formé par une masse d'épreuve qui est par exemple réalisée par micro-usinage d'une plaquette de silicium (3B) et **en ce qu'**il comprend une étape d'encapsulation du boîtier dans une enveloppe extérieure (80), ladite étape de blindage magnétique dudit boîtier incluant une opération primaire de dépôt, par galvanoplastie, d'une couche primaire dudit premier matériau ferromagnétique sur une partie au moins de ladite enveloppe extérieure (80).

11. Procédé selon l'une quelconque des revendications précédentes **caractérisé en ce que** ladite étape de blindage magnétique inclut :
- une deuxième opération de dépôt, de préférence par galvanoplastie, d'une deuxième couche d'un deuxième matériau diamagnétique ou paramagnétique, par exemple à base de cuivre, sur ladite première couche du premier matériau ferromagnétique, et
- une troisième opération de dépôt, par galvanoplastie, d'une troisième couche d'un troisième matériau ferromagnétique, sur ladite deuxième couche du deuxième matériau diamagnétique ou paramagnétique,
lesdites deuxième et troisième opérations de dépôt étant de préférence effectuées avant ladite étape d'assemblage dudit capot (100) à ladite embase (2).

12. Capteur inertiel mécanique vibrant (1) susceptible d'être fabriqué par un procédé selon l'une quelconque des revendications précédentes, ledit capteur inertiel mécanique vibrant (1) comprenant au moins une embase (2), un corps d'épreuve (3) attaché à ladite embase (2) et conçu pour vibrer et/ou se déformer et/ou se déplacer, ainsi qu'un capot (100) qui coiffe ledit corps d'épreuve (3) et forme avec l'embase (2) un boîtier qui délimite un espace intérieur au sein duquel est logé ledit corps d'épreuve (3), ledit espace intérieur étant placé sous vide ou étant rempli par un gaz sec,
le capteur inertiel étant caractérisé en que ledit boîtier est au moins en partie revêtu par une première couche d'un premier matériau ferromagnétique déposée par galvanoplastie, pour former un blindage magnétique dudit boîtier.

13. Capteur inertiel mécanique vibrant (1) selon la revendication précédente **caractérisé en ce qu'**il forme un accéléromètre vibrant, par exemple de type système microélectromécanique (MEMS), ledit corps d'épreuve (3) étant formé par une masse d'épreuve qui est par exemple réalisée par micro-usinage d'une plaquette de silicium (3B) et **en ce qu'**il comprend une enveloppe extérieure (80) au sein de laquelle est encapsulé ledit boîtier, ladite enveloppe extérieure (80) étant au moins en partie revêtue par une couche primaire dudit premier matériau ferromagnétique déposée par galvanoplastie.

14. Centrale inertielle incluant au moins une platine (4) ainsi qu'au moins un capteur inertiel mécanique vibrant (1) selon l'une quelconque des revendications 12 ou 13 ladite platine (4) étant pourvue d'au moins un support (50) auquel est fixé ledit capteur inertiel mécanique vibrant (1) pour être immobilisé par rapport à ladite platine (4), ladite centrale inertielle incluant en outre un couvercle (5) qui coiffe ledit capteur inertiel mécanique vibrant (1) et est attaché à la platine (4) pour former avec cette dernière un coffret au sein duquel est logé ledit capteur inertiel mécanique vibrant (1), ledit coffret étant au moins en partie revêtu par une couche secondaire dudit premier matériau ferromagnétique déposée par galvanoplastie.

15. Centrale inertielle selon la revendication précédente, **caractérisée en ce que** ladite platine (4) présente une face intérieure (4A) qui porte le support (50) et se trouve en regard de l'intérieur du coffret et une face extérieure (4B) opposée, tandis que le couvercle (5) présente une face intérieure (5A) disposée en regard de l'intérieur du coffret et une face extérieure (5B) opposée, ladite couche secondaire étant déposée sur lesdites faces intérieures (4A, 5A) de la platine (4) et du couvercle (5), mais pas sur leurs faces extérieures (4B, 5B).

## Patentansprüche

1. Verfahren zur Herstellung eines schwingenden mechanischen Trägheitssensors (1), umfassend einen Schritt des Verbindens eines Prüfkörpers (3) mit einem Sockel (2), wobei der Prüfkörper (3) dazu ausgelegt ist, zu schwingen und/oder sich zu verformen und/oder sich zu bewegen, wobei das Verfahren ferner einen Schritt des Zusammenbaus einer Haube (100) mit dem Sockel (2), damit die Haube (100) den Prüfkörper (3) überdeckt und mit dem Sockel (2) ein Gehäuse bildet, in dem der Prüfkörper (3) untergebracht ist, sowie einen Schritt des Evakuierens des Gehäuses oder des Füllens des Gehäuses mit einem trockenen Gas umfasst, wobei das Verfahren **dadurch gekennzeichnet ist, dass** es einen Schritt der magnetischen Abschirmung des Gehäuses umfasst, der einen ersten Abscheidungsvorgang, durch Elektroplattieren, einer ersten Schicht aus einem ersten ferromagnetischen Material auf mindestens einem Teil des Gehäuses einschließt.

2. Verfahren nach dem vorhergehenden Anspruch, **dadurch gekennzeichnet, dass** das erste ferromagnetische Material ein Material mit nanokristalliner Struktur ist, wobei die nanokristalline Struktur vorzugsweise eine mittlere Korngröße zwischen 5 und 100 nm, vorzugsweise zwischen 5 und 50 nm, noch bevorzugter zwischen 10 und 30 nm aufweist.

3. Verfahren nach einem der vorhergehenden Ansprüche, **dadurch gekennzeichnet, dass** das erste ferromagnetische Material Nickel enthält, wobei das erste ferromagnetische Material vorzugsweise eine Nickel-Eisen-Legierung ist, mit beispielsweise einem Massenanteil zwischen 45 und 80 % für Nickel und zwischen 15 und 55 % für Eisen.

4. Verfahren nach einem der vorhergehenden Ansprüche, **dadurch gekennzeichnet, dass** die erste Schicht eine Dicke von weniger als 350 µm, vorzugsweise von weniger als 300 µm, noch bevorzugter zwischen 50 und 250 µm, beispielsweise zwischen 100 und 200 µm aufweist.

5. Verfahren nach einem der vorhergehenden Ansprüche, **dadurch gekennzeichnet, dass** das erste ferromagnetische Material eine maximale relative magnetische Permeabilität von mindestens 4 500, vorzugsweise von mindestens 5 000, noch bevorzugter von mindestens 8 000, beispielsweise von mindestens 40 000 aufweist und/oder dass das erste ferromagnetische Material eine Sättigungsmagnetisierung zwischen 0,6 und 1,5 T, vorzugsweise zwischen 0,9 und 1,1 T aufweist und/oder dass das erste ferromagnetische Material eine Koerzitivfeldstärke von weniger als 80 A/m, vorzugsweise von weniger als 70 A/m, noch bevorzugter von weniger als 10 A/m, vorteilhafterweise von weniger als 3 A/m aufweist und/oder dass das erste ferromagnetische Material eine Remanenz zwischen 0,1 und 1 T, vorzugsweise zwischen 0,3 und 0,8 T aufweist.

6. Verfahren nach einem der vorhergehenden Ansprüche, **dadurch gekennzeichnet, dass** der erste Abscheidungsvorgang vor dem Schritt des Zusammenbaus der Haube (100) mit dem Sockel (2) durchgeführt wird.

7. Verfahren nach einem der vorhergehenden Ansprüche, **dadurch gekennzeichnet, dass** die Haube (100) eine Innenfläche (110), die dazu bestimmt ist, dem Inneren des Gehäuses zugewandt zu sein, und eine entgegengesetzte Außenfläche (120) aufweist, wobei die erste Schicht aus dem ersten ferromagnetischen Material während des ersten Abscheidungsvorgangs auf mindestens einem Abschnitt der Außenfläche (120) galvanisch abgeschieden wird, wobei die erste Schicht vorzugsweise auf der Außenfläche (120), nicht aber auf der Innenfläche (110) galvanisch abgeschieden wird.

8. Verfahren nach dem vorhergehenden Anspruch, **dadurch gekennzeichnet, dass** die Haube (100) eine Glockenform mit einer zylindrischen Seitenwand (100A) aufweist, die einen freien Rand (100B) besitzt, wobei der Schritt des Zusammenbaus der Haube (100) mit dem Sockel (2) einen Anlegevorgang, damit der freie Rand (100B) mit dem Sockel (2) in Kontakt kommt, sowie einen Schweiß- oder Lötvorgang einschließt, um eine Schweiß- oder Lötnaht herzustellen, die den Sockel (2) mit einem Endbereich (Z2) der zylindrischen Seitenwand (100A) verbindet, der sich in der Nähe des freien Randes (100B) auf der Außenfläche (120) befindet, wobei die erste Schicht während des ersten Abscheidungsvorgangs auf der gesamten zylindrischen Seitenwand (100A), auf der Außenfläche (120), mit Ausnahme des Endbereichs (Z2), galvanisch abgeschieden wird.

9. Verfahren nach einem der vorhergehenden Ansprüche, **dadurch gekennzeichnet, dass** der schwingende mechanische Trägheitssensor (1) ein schwingender gyroskopischer Sensor ist, wobei der Prüfkörper durch einen Resonator (3A) gebildet wird, wobei der Resonator (3A) beispielsweise einen schwingenden Zylinder (31) oder eine schwingende halbkugelförmige Schale (32) umfasst, und dass es vorzugsweise einen Schritt des Verbindens mindestens einer Anregungsvorrichtung mit dem Resonator (3A), um diesen zu Schwingungen anzuregen, sowie einen Schritt des Verbindens mindestens einer Detektionsvorrichtung mit dem Resonator (3A), um Schwingungen des Resonators (3A) zu erfassen, umfasst.

10. Verfahren nach einem der Ansprüche 1 bis 8, **dadurch gekennzeichnet, dass** der schwingende mechanische Trägheitssensor (1) ein Schwingbalken-Beschleunigungsmesser (VBA) ist, beispielsweise vom Typ mikroelektromechanisches System (MEMS), wobei der Prüfkörper (3) durch eine Prüfmasse gebildet wird, die beispielsweise durch Mikrobearbeitung eines Siliziumwafers (3B) hergestellt wird, und dass es einen Schritt der Einkapselung des Gehäuses in eine äußere Hülle (80) umfasst, wobei der Schritt der magnetischen Abschirmung des Gehäuses einen primären Abscheidungsvorgang, durch Elektroplattieren, einer Primärschicht aus dem ersten ferromagnetischen Material auf mindestens einem Teil der äußeren Hülle (80) einschließt.

11. Verfahren nach einem der vorhergehenden Ansprüche, **dadurch gekennzeichnet, dass** der Schritt der magnetischen Abschirmung Folgendes einschließt:
- einen zweiten Abscheidungsvorgang, vorzugsweise durch Elektroplattieren, einer zweiten Schicht aus einem zweiten diamagnetischen oder paramagnetischen Material, beispielsweise auf Kupferbasis, auf der ersten Schicht aus dem ersten ferromagnetischen Material, und
- einen dritten Abscheidungsvorgang, durch Elektroplattieren, einer dritten Schicht aus einem dritten ferromagnetischen Material auf der zweiten Schicht aus dem zweiten diamagnetischen oder paramagnetischen Material,
wobei der zweite und der dritte Abscheidungsvorgang vorzugsweise vor dem Schritt des Zusammenbaus der Haube (100) mit dem Sockel (2) durchgeführt werden.

12. Schwingender mechanischer Trägheitssensor (1), der durch ein Verfahren nach einem der vorhergehenden Ansprüche herstellbar ist, wobei der schwingende mechanische Trägheitssensor (1) mindestens einen Sockel (2), einen Prüfkörper (3), der an dem Sockel (2) befestigt und dazu ausgelegt ist, zu schwingen und/oder sich zu verformen und/oder sich zu bewegen, sowie eine Haube (100) umfasst, die den Prüfkörper (3) überdeckt und mit dem Sockel (2) ein Gehäuse bildet, das einen Innenraum begrenzt, in dem der Prüfkörper (3) untergebracht ist, wobei der Innenraum unter Vakuum gesetzt oder mit einem trockenen Gas gefüllt ist, wobei der Trägheitssensor **dadurch gekennzeichnet ist, dass** das Gehäuse mindestens teilweise mit einer ersten Schicht aus einem ersten ferromagnetischen Material beschichtet ist, die durch Elektroplattieren abgeschieden ist, um eine magnetische Abschirmung des Gehäuses zu bilden.

13. Schwingender mechanischer Trägheitssensor (1) nach dem vorhergehenden Anspruch, **dadurch gekennzeichnet, dass** er einen schwingenden Beschleunigungsmesser bildet, beispielsweise vom Typ mikroelektromechanisches System (MEMS), wobei der Prüfkörper (3) durch eine Prüfmasse gebildet wird, die beispielsweise durch Mikrobearbeitung eines Siliziumwafers (3B) hergestellt wird, und dass er eine äußere Hülle (80) umfasst, in der das Gehäuse eingekapselt ist, wobei die äußere Hülle (80) mindestens teilweise mit einer Primärschicht aus dem ersten ferromagnetischen Material beschichtet ist, die durch Elektroplattieren abgeschieden ist.

14. Trägheitsmesseinheit, die mindestens eine Grundplatte (4) sowie mindestens einen schwingenden mechanischen Trägheitssensor (1) nach einem der Ansprüche 12 oder 13 einschließt, wobei die Grundplatte (4) mit mindestens einer Halterung (50) versehen ist, an der der schwingende mechanische Trägheitssensor (1) befestigt ist, um gegenüber der Grundplatte (4) unbeweglich festgelegt zu sein, wobei die Trägheitsmesseinheit ferner einen Deckel (5) einschließt, der den schwingenden mechanischen Trägheitssensor (1) überdeckt und an der Grundplatte (4) befestigt ist, um mit dieser einen Kasten zu bilden, in dem der schwingende mechanische Trägheitssensor (1) untergebracht ist, wobei der Kasten mindestens teilweise mit einer Sekundärschicht aus dem ersten ferromagnetischen Material beschichtet ist, die durch Elektroplattieren abgeschieden ist.

15. Trägheitsmesseinheit nach dem vorhergehenden Anspruch, **dadurch gekennzeichnet, dass** die Grundplatte (4) eine Innenfläche (4A), welche die Halterung (50) trägt und dem Inneren des Kastens zugewandt ist, und eine entgegengesetzte Außenfläche (4B) aufweist, während der Deckel (5) eine Innenfläche (5A), die dem Inneren des Kastens zugewandt angeordnet ist, und eine entgegengesetzte Außenfläche (5B) aufweist, wobei die Sekundärschicht auf den Innenflächen (4A, 5A) der Grundplatte (4) und des Deckels (5), nicht aber auf deren Außenflächen (4B, 5B) abgeschieden ist.

## Claims

1. A method for manufacturing a vibrating mechanical inertial sensor (1), comprising a step of associating a proof body (3) with a base (2), said proof body (3) being designed to vibrate and/or to deform and/or to move, said method further comprising a step of assembling a cap (100) to said base (2) so that said cap (100) caps the proof body (3) and forms with the base (2) a housing within which said proof body (3) is accommodated, a step of drawing a vacuum in said housing or of filling said housing with a dry gas, the method being **characterised in that** it comprises a magnetic shielding step of said housing which includes a first deposition operation, by electroplating, of a first layer of a first ferromagnetic material on at least a part of said housing.

2. A method according to the preceding claim, **characterised in that** said first ferromagnetic material is a material having a nanocrystalline structure, said nanocrystalline structure preferably having a mean grain size of between 5 and 100 nm, preferably of between 5 and 50 nm, still more preferably of between 10 and 30 nm.

3. A method according to any one of the preceding claims, **characterised in that** said first ferromagnetic material includes nickel, said first ferromagnetic material preferably being a nickel-iron alloy, with for example a mass percentage of between 45 and 80% for the nickel and of between 15 and 55% for the iron.

4. A method according to any one of the preceding claims, **characterised in that** said first layer has a thickness of less than 350 µm, preferably of less than 300 µm, still more preferably of between 50 and 250 µm, for example of between 100 and 200 µm.

5. A method according to any one of the preceding claims, **characterised in that** said first ferromagnetic material has a maximum relative magnetic permeability at least equal to 4 500, preferably at least equal to 5 000, still more preferably at least equal to 8 000, for example at least equal to 40 000, and/or said first ferromagnetic material has a saturation magnetisation of between 0.6 and 1.5 T, preferably of between 0.9 and 1.1 T, and/or said first ferromagnetic material has a coercivity of less than 80 A/m, preferably of less than 70 A/m, still more preferably of less than 10 A/m, advantageously of less than 3 A/m, and/or said first ferromagnetic material has a remanence of between 0.1 and 1 T, preferably of between 0.3 and 0.8 T.

6. A method according to any one of the preceding claims, **characterised in that** said first deposition operation is carried out before said step of assembling said cap (100) to said base (2).

7. A method according to any one of the preceding claims, **characterised in that** said cap (100) has an inner face (110) intended to be located facing the inside of the housing and an opposite outer face (120), said first layer of the first ferromagnetic material being electrodeposited on at least a portion of said outer face (120) during said first deposition operation, said first layer preferably being electrodeposited on said outer face (120) but not on said inner face (110).

8. A method according to the preceding claim, **characterised in that** said cap (100) has a bell shape with a cylindrical side wall (100A) having a free edge (100B), said step of assembling the cap (100) to the base (2) including an abutment operation so that said free edge (100B) comes into contact with said base (2) and a welding or brazing operation in order to produce a weld or braze bead connecting the base (2) to an end zone (Z2) of the cylindrical side wall (100A) located in the vicinity of the free edge (100B) on the outer face (120), said first layer being electrodeposited, during said first deposition operation, on the whole of the cylindrical side wall (100A), on the outer face (120), except in said end zone (Z2).

9. A method according to any one of the preceding claims, **characterised in that** said vibrating mechanical inertial sensor (1) is a vibrating gyroscopic sensor, said proof body being formed by a resonator (3A), said resonator (3A) comprising for example a vibrating cylinder (31) or a vibrating hemispherical shell (32), and **in that** it preferably comprises a step of associating at least one excitation device with said resonator (3A) in order to excite it into vibration, as well as a step of associating at least one detection device with said resonator (3A) in order to detect vibrations of said resonator (3A).

10. A method according to any one of claims 1 to 8, **characterised in that** said vibrating mechanical inertial sensor (1) is a vibrating beam accelerometer (VBA), for example of the microelectromechanical system (MEMS) type, said proof body (3) being formed by a proof mass which is for example produced by micromachining a silicon wafer (3B), and **in that** it comprises a step of encapsulating the housing in an outer envelope (80), said magnetic shielding step of said housing including a primary deposition operation, by electroplating, of a primary layer of said first ferromagnetic material on at least a part of said outer envelope (80).

11. A method according to any one of the preceding claims, **characterised in that** said magnetic shielding step includes:
- a second deposition operation, preferably by electroplating, of a second layer of a second diamagnetic or paramagnetic material, for example copper-based, on said first layer of the first ferromagnetic material, and
- a third deposition operation, by electroplating, of a third layer of a third ferromagnetic material, on said second layer of the second diamagnetic or paramagnetic material,
said second and third deposition operations preferably being carried out before said step of assembling said cap (100) to said base (2).

12. A vibrating mechanical inertial sensor (1) capable of being manufactured by a method according to any one of the preceding claims, said vibrating mechanical inertial sensor (1) comprising at least one base (2), a proof body (3) attached to said base (2) and designed to vibrate and/or to deform and/or to move, as well as a cap (100) which caps said proof body (3) and forms with the base (2) a housing which delimits an inner space within which said proof body (3) is accommodated, said inner space being placed under vacuum or being filled with a dry gas, the inertial sensor being **characterised in that** said housing is at least partly coated with a first layer of a first ferromagnetic material deposited by electroplating, in order to form a magnetic shield of said housing.

13. A vibrating mechanical inertial sensor (1) according to the preceding claim, **characterised in that** it forms a vibrating accelerometer, for example of the microelectromechanical system (MEMS) type, said proof body (3) being formed by a proof mass which is for example produced by micromachining a silicon wafer (3B), and **in that** it comprises an outer envelope (80) within which said housing is encapsulated, said outer envelope (80) being at least partly coated with a primary layer of said first ferromagnetic material deposited by electroplating.

14. An inertial unit including at least one plate (4) as well as at least one vibrating mechanical inertial sensor (1) according to any one of claims 12 or 13, said plate (4) being provided with at least one support (50) to which said vibrating mechanical inertial sensor (1) is fastened so as to be immobilised with respect to said plate (4), said inertial unit further including a cover (5) which caps said vibrating mechanical inertial sensor (1) and is attached to the plate (4) in order to form therewith a casing within which said vibrating mechanical inertial sensor (1) is accommodated, said casing being at least partly coated with a secondary layer of said first ferromagnetic material deposited by electroplating.

15. An inertial unit according to the preceding claim, **characterised in that** said plate (4) has an inner face (4A) which carries the support (50) and is located facing the inside of the casing and an opposite outer face (4B), whereas the cover (5) has an inner face (5A) arranged facing the inside of the casing and an opposite outer face (5B), said secondary layer being deposited on said inner faces (4A, 5A) of the plate (4) and of the cover (5), but not on their outer faces (4B, 5B).
